# FASCICULE DE BREVET EUROPEEN

(11) **EP 3 563 420 B1**
(45) Date de publication et mention de la délivrance du brevet: **16.06.2021**
(21) Numéro de dépôt: 17832297.0
(22) Date de dépôt: 22.12.2017
(51) Int. Cl.: H01L 27/15, H01L 33/50, H01L 33/60

(54) **PROCEDE DE FABRICATION D'UN DISPOSITIF OPTOELECTRONIQUE COMPORTANT DES PLOTS PHOTOLUMINESCENTS DE PHOTORESINE**
VERFAHREN ZUR HERSTELLUNG EINER OPTOELEKTRONISCHEN VORRICHTUNG MIT FOTOLUMINESZENTEN PADS AUS FOTOLACK
PROCESS FOR FABRICATING AN OPTOELECTRONIC DEVICE INCLUDING PHOTOLUMINESCENT PADS OF PHOTORESIST

(30) Priorité: 27.12.2016 FR 1663410
(43) Date de publication de la demande: 06.11.2019
(73) Titulaire: Aledia, 38040 Grenoble (FR)
(72) Inventeur: POURQUIER, Eric, 38000 Grenoble (FR); GILET, Philippe, 38470 Teche (FR); YING-LAN, Chang, Cupertino, California CA 95014 (US)
(74) Mandataire: INNOV-GROUP
(86) Numéro de dépôt international: PCT/FR2017/053826
(87) Numéro de publication internationale: WO 2018/122520

(56) Documents cités:
- WO-A1-2014/140505
- JP-A- 2004 071 357
- US-A1- 2011 227 106
- US-A1- 2015 221 619
- US-A1- 2016 141 469
- US-A1- 2016 197 064

## Description

### DOMAINE TECHNIQUE

Le domaine de l'invention est celui des procédés de fabrication des dispositifs optoélectroniques comportant des diodes électroluminescentes associées à des plots photoluminescents. L'invention trouve une application notamment dans les écrans d'affichage ou les systèmes de projection d'images.

### ÉTAT DE LA TECHNIQUE ANTÉRIEURE

Il existe des dispositifs optoélectroniques comportant une matrice de diodes électroluminescentes présentant une surface d'émission, cette surface d'émission étant revêtue au moins en partie par des plots photoluminescents. De tels dispositifs optoélectroniques peuvent former des écrans d'affichage ou des systèmes de projection d'images comportant une matrice de pixels lumineux de différentes couleurs.

Les diodes électroluminescentes peuvent être formées à base d'un matériau semiconducteur comprenant des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AlGaN). Elles sont agencées de manière à former une matrice de diodes électroluminescentes présentant une surface d'émission au travers de laquelle est transmis le rayonnement lumineux émis par les diodes électroluminescentes. US2016141469 divulgue un procédé de l'art antérieur pour former des blocs photoluminescents en utilisant un matériau photoluminescent incorporé dans une couche de matériel photosensible. US2011227106 et JP2004071357 divulguent des procédés et des dispositifs de l'art antérieur ayant des plots photoluminescents de différentes couleurs.

Dans le cas d'un écran d'affichage ou d'un système de projection d'image, le dispositif optoélectronique peut ainsi comporter une matrice de pixels lumineux, chaque pixel lumineux comportant une ou plusieurs diodes électroluminescentes. Dans le but d'obtenir des pixels lumineux adaptés à émettre des lumières de différentes couleurs, par exemple bleues, vertes ou rouges, les diodes électroluminescentes peuvent être adaptées à émettre une lumière bleue, et certains pixels lumineux peuvent comporter des plots photoluminescents adaptés à absorber au moins en partie la lumière bleue émise par les diodes électroluminescentes, et à émettre en réponse une lumière verte ou rouge. Les plots photoluminescents sont habituellement formés d'une matrice liante comportant des particules d'un matériau photoluminescent tel que le grenat d'yttrium et d'aluminium (YAG, pour *Yttrium Aluminium Garnet,* en anglais) activé par l'ion cérium YAG:Ce.

D'une manière générale, il existe un besoin de disposer d'un procédé de fabrication d'un dispositif optoélectronique permettant d'augmenter la résolution tout en optimisant le contraste.

### EXPOSÉ DE L'INVENTION

L'invention a pour but de proposer un procédé de fabrication d'un dispositif optoélectronique à diodes électroluminescentes, comportant des plots photoluminescents, qui permette d'obtenir des dispositifs optoélectroniques à haute résolution et fort contraste.

Pour cela, l'objet de l'invention est un procédé de fabrication d'un dispositif optoélectronique comportant une matrice de diodes électroluminescentes et une pluralité de plots photoluminescents situés chacun en vis-à-vis d'au moins une partie desdites diodes électroluminescentes, comportant les étapes suivantes :
- formation de ladite pluralité de plots photoluminescents par photolithographie d'au moins une résine photosensible contenant des particules photoluminescentes préalablement déposée sur une surface support ;
- formation de parois réfléchissantes recouvrant des flancs latéraux desdits plots photoluminescents, par dépôt d'au moins une portion de couche mince sur les flancs latéraux.

Certains aspects préférés mais non limitatifs de ce procédé sont les suivants.

L'étape de formation des parois réfléchissantes peut comporter un dépôt conforme d'au moins une couche mince en un matériau réfléchissant de manière à recouvrir les plots photoluminescents, puis gravure localisée de la couche mince déposée, de manière à rendre libre une surface dite supérieure des plots photoluminescents opposée à ladite surface support.

Les étapes de formation de la pluralité de plots photoluminescents, et de formation des parois réfléchissantes peuvent comporter les étapes suivantes :
- formation d'une pluralité de premiers plots photoluminescents, par photolithographie d'une première résine photosensible contenant des premières particules photoluminescentes préalablement déposée sur ladite surface support ;
- formation de premières parois réfléchissantes recouvrant des flancs latéraux desdits premiers plots photoluminescents par dépôt conforme d'une couche mince réfléchissante sur les premiers plots photoluminescents, puis gravure localisée de manière à rendre libre une surface supérieure des premiers plots photoluminescents ;
- formation d'une pluralité de deuxièmes plots photoluminescents, par photolithographie d'une deuxième résine photosensible contenant des deuxièmes particules photoluminescentes préalablement déposée sur ladite surface support, les deuxièmes particules photoluminescentes étant différentes des premières particules photoluminescentes.

Le procédé peut comporter, à la suite de l'étape de formation de la pluralité de deuxièmes plots photoluminescents, une étape de formation de deuxièmes parois réfléchissantes recouvrant des flancs latéraux desdits deuxièmes plots photoluminescents par dépôt conforme d'une couche mince réfléchissante sur les premiers et deuxièmes plots photoluminescents, puis gravure localisée de manière à rendre libre la surface supérieure des premiers et deuxièmes plots photoluminescents.

Chaque deuxième plot photoluminescent peut être en contact d'au moins une première paroi réfléchissante.

Chaque première paroi réfléchissante peut présenter une épaisseur comprise entre 10nm et 500nm.

L'étape de formation de la pluralité de plots photoluminescents peut comporter au moins une formation de plusieurs premiers plots photoluminescents contenant des premières particules photoluminescentes suivie d'une formation de plusieurs deuxièmes plots photoluminescents contenant des deuxièmes particules photoluminescentes différentes des premières particules photoluminescents, l'étape de formation des parois réfléchissantes étant effectuée après les formations d'au moins les premiers et deuxièmes plots photoluminescents.

Les parois réfléchissantes peuvent être formées par dépôt électrochimique.

La taille moyenne des particules photoluminescentes peut être inférieure ou égale à 500nm.

Les particules photoluminescentes peuvent être des boîtes quantiques, et peuvent présenter une taille moyenne inférieure ou égale à 50nm.

Les plots photoluminescents peuvent présenter une hauteur moyenne inférieure ou égale à 30µm.

Les diodes électroluminescentes peuvent être des éléments tridimensionnels allongés s'étendant longitudinalement de manière sensiblement orthogonale à un plan principal d'une couche support.

Les diodes électroluminescentes peuvent être situées à l'intérieur des plots de résine photosensible, dont au moins une partie des plots sont des plots photoluminescents comportant des particules photoluminescentes.

Les plots photoluminescents peuvent reposer sur une surface support, dite surface de transmission, formée par une couche d'espacement recouvrant les diodes électroluminescentes.

L'invention porte également sur un dispositif optoélectronique, comportant :
- une matrice de diodes électroluminescentes reposant sur une couche support ;
- une pluralité de premiers plots photoluminescents, situés chacun en vis-à-vis d'au moins une partie desdites diodes électroluminescentes, formés chacun d'une première résine photosensible comportant des premières particules photoluminescentes, ayant des flancs latéraux recouverts par une portion de couche mince déposée formant une première paroi réfléchissante ;
- une pluralité de deuxièmes plots photoluminescents, situés chacun en vis-à-vis d'au moins une partie desdites diodes électroluminescentes, formés chacun d'une deuxième résine photosensible comportant des deuxièmes particules photoluminescentes différentes des premières particules photoluminescentes, ayant des flancs latéraux recouverts par une portion de couche mince déposée formant une deuxième paroi réfléchissante.

Chaque deuxième plot photoluminescent peut être au contact d'une première paroi réfléchissante.

Les diodes électroluminescentes peuvent présenter une structure tridimensionnelle allongée suivant un axe longitudinal sensiblement orthogonal à la couche support.

Les diodes électroluminescentes peuvent être situées à l'intérieur des plots photoluminescents.

Les diodes électroluminescentes peuvent présenter une structure en mesa.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

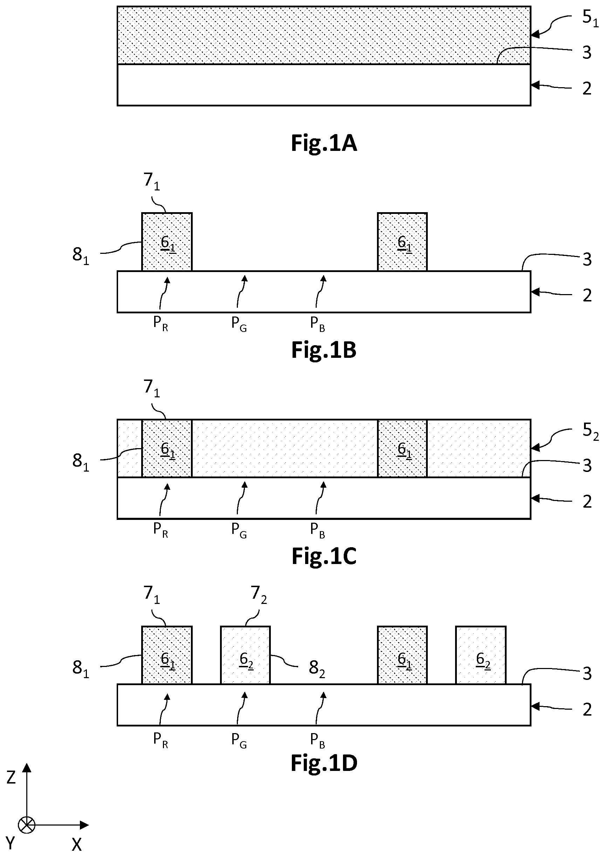

les figures 1A à 1F sont des vues schématiques et partielles, en coupe transversale, de différentes étapes d'un procédé de fabrication selon un premier mode de réalisation, dans lequel les plots photoluminescents sont réalisés par photolithographie de différentes résines photosensibles contenant des particules photoluminescentes ;

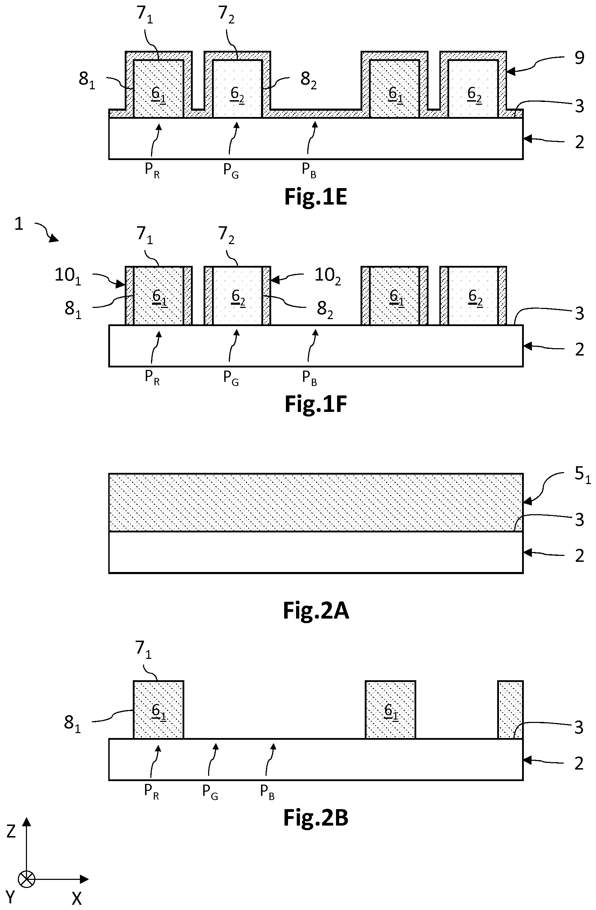

les figures 2A à 2H sont des vues schématiques et partielles, en coupe transversale, de différentes étapes d'un procédé de fabrication selon un deuxième mode de réalisation, dans lequel la résolution des pixels peut être augmentée par rapport à celle obtenue dans le cadre du procédé selon le premier mode de réalisation ;

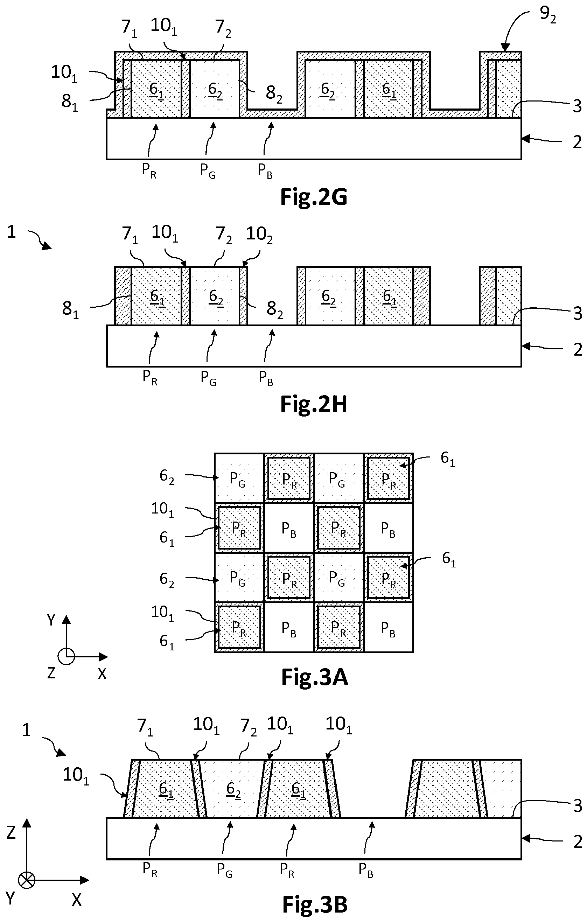

la figure 3A est une vue de dessus, schématique et partielle, d'une variante du procédé de fabrication selon le deuxième mode de réalisation, dans lequel les flancs latéraux de chaque deuxième plot photoluminescent sont au contact de premières parois réfléchissantes, dans le cas ici d'un exemple de matrice de Bayer ; et la figure 3B est une vue schématique et partielle, en coupe transversale, d'un dispositif optoélectronique obtenu à partir d'une autre variante du procédé de fabrication selon le deuxième mode de réalisation, dans lequel les parois réfléchissantes sont inclinées ;

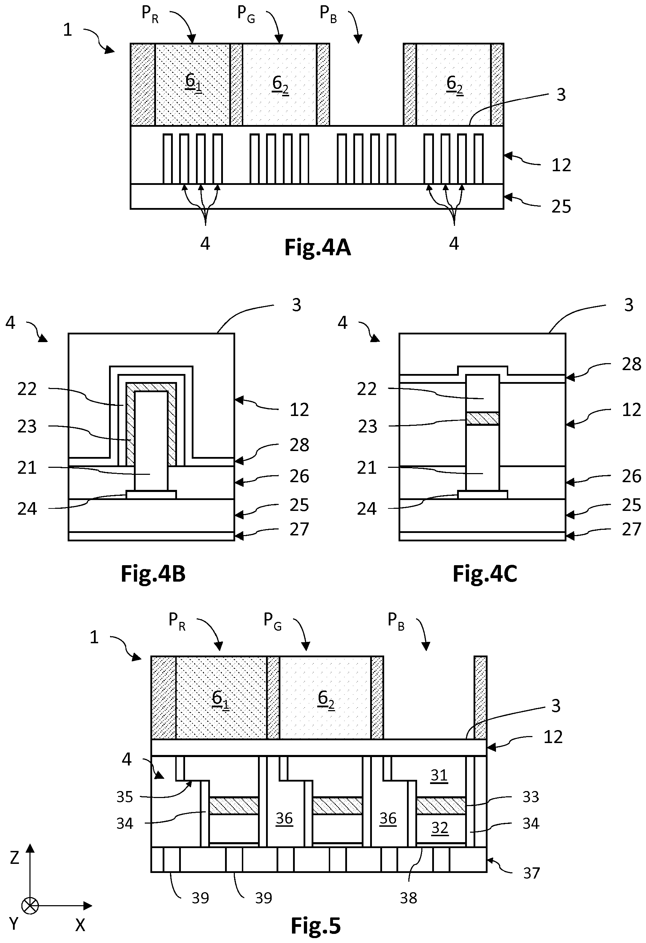

la figure 4A est une vue schématique et partielle, en coupe transversale, d'un dispositif optoélectronique obtenu par le procédé de fabrication selon le deuxième mode de réalisation, dans lequel les diodes électroluminescentes sont de type filaire, la figure 4B illustre de manière détaillée un exemple de diodes électroluminescentes filaires en configuration cœur/coquille et la figure 4C illustre un autre exemple de diodes électroluminescentes filaires en configuration axiale ;
la figure 5 est une vue schématique et partielle, en coupe transversale, d'un dispositif optoélectronique obtenu par le procédé de fabrication selon le deuxième mode de réalisation, dans lequel les diodes électroluminescentes sont de type mesa ;

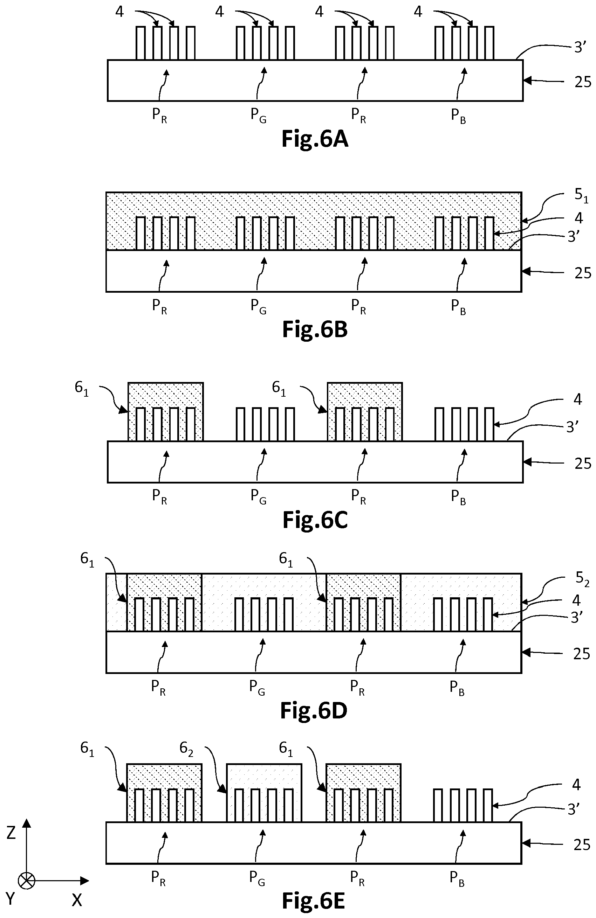

les figures 6A à 6I sont des vues schématiques et partielles, en coupe transversale, de différentes étapes d'un procédé de fabrication selon un troisième mode de réalisation, dans lequel les diodes électroluminescentes sont situées à l'intérieur des plots de résine photosensible ; et

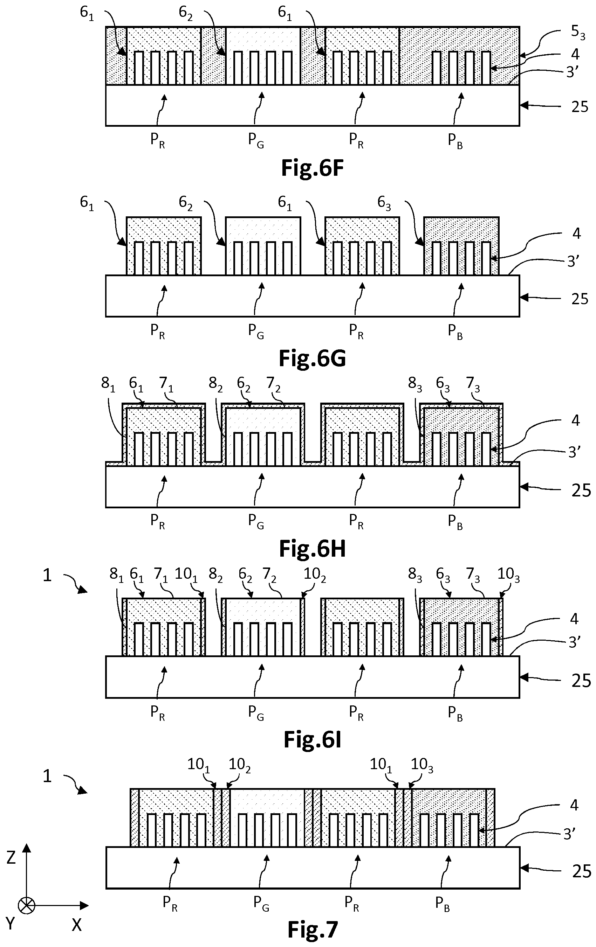

la figure 7 est une vue schématique et partielle, en coupe transversale, d'un dispositif optoélectronique obtenu par une variante du procédé selon le deuxième mode de réalisation, dans lequel les parois réfléchissantes de deux plots photoluminescents adjacents sont au contact l'une avec l'autre.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près.

L'invention porte sur un procédé de fabrication d'un dispositif optoélectronique à diodes électroluminescentes comportant des plots photoluminescents. Plus précisément, le dispositif optoélectronique comporte une matrice de diodes électroluminescentes réparties en différents pixels lumineux, les plots photoluminescents étant situés chacun en vis-à-vis d'au moins une partie des diodes électroluminescentes. Par situés en vis-à-vis, on entend que les plots photoluminescents sont situés en regard des diodes électroluminescentes et peuvent être espacés ou au contact de ces dernières.

Selon un mode de réalisation détaillé plus loin, les plots photoluminescents peuvent être situés en vis-à-vis des diodes électroluminescentes et espacés de ces dernières par une couche d'espacement. Autrement dit, les plots photoluminescents ne sont pas au contact des diodes électroluminescentes. Ils peuvent reposer sur une surface support dite de transmission optique de la couche d'espacement. La surface de transmission est la surface de la couche d'espacement au travers de laquelle est transmis le rayonnement lumineux dit d'excitation émis par les diodes électroluminescentes en direction des plots photoluminescents. En variante, la surface de transmission peut être une surface d'une plaque transparente sur laquelle les plots photoluminescents ont été préalablement réalisés, la plaque transparente étant ensuite rapportée et fixée à la matrice de diodes électroluminescentes, par exemple sur la couche d'espacement.

Selon un autre mode de réalisation détaillé plus loin, les plots photoluminescents peuvent être situés en vis-à-vis des diodes électroluminescentes et au contact de ces dernières. Autrement dit, au niveau d'un pixel lumineux, les diodes électroluminescentes sont situées à l'intérieur et au contact du plot photoluminescent correspondant. Le plot photoluminescent entoure alors chacune des diodes électroluminescentes correspondantes. Les diodes électroluminescentes et les plots photoluminescents reposent sur une même surface support d'une couche dite support. Ce mode de réalisation porte plus particulièrement sur les diodes électroluminescentes de type filaire.

Les plots photoluminescents sont adaptés à convertir au moins en partie un rayonnement lumineux d'excitation émis par les diodes électroluminescentes en un rayonnement lumineux dit de luminescence d'une longueur d'onde différente. Chaque plot photoluminescent comporte une matrice liante transparente aux rayonnements lumineux d'excitation et de luminescence dans laquelle sont dispersées des particules photoluminescentes. Les plots photoluminescents reposent sur une surface support, par exemple une surface d'une couche support sur laquelle reposent également les diodes électroluminescentes ou une surface d'une couche d'espacement transparente qui recouvre les diodes électroluminescentes, voire une surface d'une plaque transparente rapportée. Chaque plot photoluminescent comporte une surface dite supérieure opposée à la surface support, destinée à transmettre un rayonnement lumineux de luminescence, et des flancs latéraux qui s'étendent à partir de la surface supérieure jusqu'à la surface support et délimitent ainsi latéralement le plot.

La matrice liante des plots photoluminescents est ici une résine photosensible, ou photorésine. Par résine photosensible, on entend ici un matériau dont la solubilité à un solvant dit développeur varie sous l'effet d'un rayonnement lumineux déterminé qui lui est appliqué, ici dans le cadre d'une étape de photolithographie. Elle peut être choisie parmi les résines positives ou négatives, ces catégories de résine photosensible étant connues de l'homme du métier. Chaque plot photoluminescent est formé d'une résine photosensible, qui peut être identique ou différente d'un plot à l'autre, comportant les particules photoluminescentes.

La résine photosensible est transparente et optiquement inerte aux rayonnements lumineux émis par les diodes électroluminescentes et par les particules photoluminescentes. Ainsi, la résine transmet au moins 50% de la lumière émise par les diodes électroluminescentes et de celle émise par les particules photoluminescentes, et de préférence au moins 80%, et elle n'émet pas de lumière en réponse à une absorption de cette lumière. Elle peut être choisie parmi le silicone, ou polysiloxane, tel que le polydiméthylsiloxane (PDMS), la résine SU-8, les polymères thermoplastiques tels que le polyméthacrylate de méthyle (PMMA), le polyimide, ou parmi d'autres résines photosensibles pouvant convenir.

Les particules photoluminescentes sont des éléments d'au moins un matériau photoluminescent adapté à convertir au moins en partie la lumière d'excitation en une lumière de luminescence de plus grande longueur d'onde. A titre illustratif, elles peuvent être adaptées à absorber de la lumière bleue, c'est-à-dire dont la longueur d'onde est comprise entre 440nm et 490nm environ, et à émettre dans le vert, c'est-à-dire à une longueur d'onde comprise entre 495nm et 560nm environ, voire dans le rouge, c'est-à-dire à une longueur d'onde comprise entre 600nm et 650nm. Par longueur d'onde, on entend ici la longueur d'onde pour laquelle le spectre d'émission présente un pic d'intensité. A titre purement illustratif, les diodes électroluminescentes peuvent présenter un spectre d'émission dont le pic d'intensité est compris entre 380nm et 490nm.

Les particules photoluminescentes sont distinctes les unes des autres, et présentent une forme qui peut être quelconque, par exemple sphérique, anguleuse, aplatie, allongée, ou de toute autre forme. La taille d'une particule est ici la plus petite dimension de la particule, et la taille moyenne est la moyenne arithmétique des tailles des particules. Les particules photoluminescentes peuvent présenter une taille moyenne comprise entre 0,2nm et 1000nm, par exemple inférieure à 500nm, par exemple inférieure à 100nm, et de préférence inférieure à 50nm.

De préférence, les particules photoluminescentes se présentent sous la forme de boîtes quantiques (*quantum dots,* en anglais), c'est-à-dire sous la forme de nanocristaux semiconducteurs dont le confinement quantique est sensiblement tridimensionnel. La taille moyenne des boîtes quantiques peut alors être comprise entre 0,2nm et 50nm, par exemple entre 1nm et 30nm. Les boîtes quantiques peuvent être formées d'au moins un composé semiconducteur, qui peut être choisi parmi le séléniure de cadmium (CdSe), le phosphore d'indium (InP), le phosphore de gallium et d'indium (InGaP), le sulfure de cadmium (CdS), le sulfure de zinc (ZnS), l'oxyde de cadmium (CdO) ou de zinc (ZnO), le séléniure de zinc et de cadmium (CdZnSe), le séléniure de zinc (ZnSe) dopé par exemple au cuivre ou au manganèse, le graphène ou parmi d'autres matériaux semiconducteurs pouvant convenir. Les boîtes quantiques peuvent également présenter une structure de type cœur/ coquille, tel que CdSe/ZnS, CdSe/CdS, CdSe/CdS/ZnS, PbSe/PbS, CdTe/CdSe, CdSe/ZnTe, InP/ZnS ou autre. La taille et/ou la composition des particules photoluminescentes sont choisies en fonction de la longueur d'onde de luminescence désirée.

Les plots photoluminescents se présentent sous la forme d'un bloc de résine photosensible, dont l'épaisseur est définie comme étant la plus grande dimension suivant un axe orthogonal à la surface sur laquelle ils reposent. La section droite des plots, dans un plan parallèle à ladite surface sur laquelle ils reposent, peut présenter différentes formes, par exemple une forme circulaire, ovale, polygonale par exemple triangulaire, carrée, rectangulaire, voire hexagonale. On définit ici la largeur d'un plot comme étant une dimension transversale du plot au niveau d'une section droite. La largeur locale est la largeur du plot à une hauteur donnée de celui-ci. La largeur moyenne est la moyenne, par exemple arithmétique, des largeurs locales suivant la dimension d'épaisseur du plot.

L'épaisseur d'un plot photoluminescent peut être comprise entre 0,1µm et 50µm, et de préférence comprise entre 1µm et 30µm, par exemple égale à 20µm environ. La largeur d'un plot photoluminescent dépend de celle d'un pixel lumineux et donc de l'application du dispositif optoélectronique. Elle peut être comprise entre 0,5µm et 100µm, par exemple comprise entre 1µm et 20µm, par exemple égale à 10µm environ dans le cas d'un écran d'affichage ou d'un système de projection. Par ailleurs, la fraction massique de particules photoluminescentes dans la résine photosensible peut être comprise entre 10% et 70%, et de préférence comprise entre 25% et 60%, par exemple égale à 30%. Elle est adaptée notamment en fonction de l'épaisseur du plot photoluminescent de manière à permettre l'insolation de la résine photosensible sur toute son épaisseur lors d'une étape de photolithographie, ainsi que du taux de conversion de lumière désiré.

Les figures 1A à 1F illustrent un procédé de fabrication d'un dispositif optoélectronique à diodes électroluminescentes selon un premier mode de réalisation.

On définit ici et pour la suite de la description un repère direct tridimensionnel (X,Y,Z), où le plan (X,Y) est sensiblement parallèle au plan principal d'une puce optoélectronique 2, et où l'axe Z est orienté suivant une direction orthogonale au plan XY.

La figure 1A illustre la fourniture d'une matrice de diodes électroluminescentes, présentant une surface de transmission 3, suivie d'un dépôt d'une première résine photosensible 5₁ comportant des premières particules photoluminescentes.

La matrice de diodes électroluminescentes (non représentées) est formée ici dans une puce optoélectronique 2, et définit une matrice de pixels lumineux P. Une surface de la puce optoélectronique 2 forme la surface de transmission 3 de la matrice de diodes électroluminescentes. La surface de transmission 3 est ici sensiblement plane, moyennant la présence éventuelle de micro-structurations de surface permettant d'améliorer l'extraction de lumière.

Les diodes électroluminescentes sont ici réalisées à base d'un même composé semiconducteur, par exemple à base d'un composé III-V tel que le GaN. Par réalisées à base de, on entend que les diodes électroluminescentes comportent majoritairement ledit composé semiconducteur. Comme détaillé plus loin, chaque diode électroluminescente comporte un empilement d'une première et d'une deuxième portion semiconductrice dopée, entre lesquelles se situe une zone active. La zone active est la région d'une diode électroluminescente où un rayonnement lumineux est émis. Les diodes électroluminescentes peuvent présenter différentes structures, telles que des structures filaires ou en mesa dont des exemples sont respectivement décrits plus loin en référence aux figures 4B et 4C, et à la figure 5. Dans cet exemple, les diodes électroluminescentes sont adaptées à émettre une lumière bleue, c'est-à-dire une lumière dont le spectre d'émission présente un pic d'intensité à une longueur d'onde comprise entre 440nm et 490nm environ.

Une première résine photosensible 5₁ est déposée sur les diodes électroluminescentes, ici sans être au contact avec ces dernières. Plus précisément, elle est déposée sur une surface support, ici la surface de transmission 3 de la puce optoélectronique 2, de manière à être située en vis-à-vis des diodes électroluminescentes. La première résine photosensible 5₁ comporte des premières particules photoluminescentes, ici des boîtes quantiques, adaptées à convertir au moins en partie la lumière bleue émise par les diodes électroluminescentes en une lumière rouge, verte ou autre, par exemple ici en lumière rouge. La résine photosensible 5₁ peut être déposée sur la totalité de la surface de transmission 3. Elle peut être déposée par une technique classique connue de l'homme du métier, par exemple par dépôt à la tournette, pulvérisation de type spray, héliographie, sérigraphie ou autre.

La résine photosensible 5₁ présente une épaisseur locale sensiblement constante sur toute l'étendue de la surface de transmission 3, et présente une épaisseur moyenne de préférence comprise entre 0,1µm et 50µm, de préférence comprise entre 1µm et 40µm, par exemple égale à 20µm environ.

Dans cet exemple, elle comporte des particules photoluminescentes, ici des boîtes quantiques, adaptées à convertir au moins partiellement la lumière bleue émise par les diodes électroluminescentes en lumière rouge. A titre d'exemple, des boîtes quantiques formées de nanocristaux semiconducteurs de CdSe dont la taille moyenne est comprise entre 3nm et 12nm, par exemple égale à 3,6nm environ, sont adaptées à convertir de la lumière bleue en lumière rouge. La première résine photosensible 5₁ présente une fraction massique de boîtes quantiques qui peut être comprise entre 10% et 70%, et de préférence comprise entre 25% et 60%, par exemple égale à 30% environ.

La figure 1B illustre une étape de formation de premiers plots photoluminescents 6₁ par photolithographie de la première résine photosensible 5₁. Les premiers plots 6₁ sont distincts les uns des autres et sont positionnés sur la surface de transmission 3 au niveau de pixels P_{R} destinés à émettre une lumière rouge.

Dans cet exemple, les premiers plots photoluminescents 6₁ présentent des dimensions sensiblement identiques les uns aux autres. Ils sont formés ici d'un bloc de première résine photosensible 5₁ à section droite dans le plan XY sensiblement carrée ou rectangulaire. Chaque premier plot photoluminescent 6₁ comporte alors une surface dite supérieure 7₁, opposée à la surface de transmission 3, et des flancs latéraux 8₁ qui s'étendent à partir de la surface supérieure 7₁ jusqu'à la surface de transmission 3. Autrement dit, les diodes électroluminescentes reposent sur une couche support (non représentée) de la puce optoélectronique, et la surface supérieure des plots photoluminescents est la surface des plots opposée à la couche support suivant l'axe Z. L'épaisseur des premiers plots 6₁ est ici sensiblement égale à 20µm et la largeur moyenne est sensiblement égale à la taille d'un pixel, par exemple ici égale à 10µm environ.

La figure 1C illustre une étape de dépôt d'une deuxième résine photosensible 5₂ sur la surface de transmission 3. Elle peut être déposée par l'une des techniques mentionnées précédemment, de manière à recouvrir la surface de transmission 3 non revêtue par les premiers plots photoluminescents 6₁. Elle vient ainsi au contact des flancs latéraux 8₁ des premiers plots photoluminescents 6₁. Elle présente dans cet exemple une épaisseur sensiblement égale à celle des premiers plots photoluminescents 6₁ mais peut présenter une épaisseur différente, par exemple supérieure.

Dans cet exemple, la deuxième résine photosensible 5₂ comporte des deuxièmes particules photoluminescentes, ici des boîtes quantiques, adaptées à convertir au moins en partie la lumière bleue émise par les diodes électroluminescentes en une lumière différente de celle émise par les premières particules photoluminescentes, par exemple ici en lumière verte. A titre d'exemple, des boîtes quantiques formées de nanocristaux semiconducteurs de CdSe dont la taille moyenne est égale à 1,3nm environ sont adaptées à convertir de la lumière bleue en lumière verte. La deuxième résine photosensible 5₂ peut présenter une fraction massique de boîtes quantiques identique ou différente de celle de la première résine photosensible 5₁. Alors que les deuxièmes particules photoluminescentes sont différentes des premières particules photoluminescentes, la matrice liante formant la deuxième résine photosensible 5₂ peut être identique à celle formant la première résine photosensible 5₁.

La figure 1D illustre une étape de formation de deuxièmes plots photoluminescents 6₂ par photolithographie de la deuxième résine photosensible 5₂. Les deuxièmes plots 6₂ sont distincts les uns des autres et sont également distincts des premiers plots 6₁, dans le sens où ils ne sont pas au contact les uns des autres. Ils sont positionnés sur la surface de transmission 3 au niveau de pixels P_{G} destinés à émettre une lumière verte.

Les deuxièmes plots photoluminescents 6₂ peuvent présenter des dimensions identiques ou différentes d'un deuxième plot 6₂ à l'autre, et identiques ou différentes de celles des premiers plots 6₁. Dans cet exemple, les différents plots 6₁, 6₂ présentent des dimensions sensiblement identiques entre eux. Les deuxièmes plots photoluminescents 6₂ sont ainsi formés d'un bloc de deuxième résine photosensible 5₂ à section droite sensiblement carrée ou rectangulaire dans le plan XY. Comme pour les premiers plots, chaque deuxième plot photoluminescent 6₂ comporte une surface dite supérieure 7₂, opposée à la surface de transmission 3, et des flancs latéraux 8₂ qui s'étendent à partir de la surface supérieure 7₂ jusqu'à la surface de transmission 3.

La distance minimale, dans le plan XY, séparant chaque plot photoluminescent 6₁, 6₂ des plots voisins 6₁, 6₂ est adaptée à permettre la formation de parois réfléchissantes 10₁, 10₂ recouvrant les flancs latéraux 8₁, 8₂ des plots photoluminescents 6₁, 6₂. Cette distance peut ainsi être de l'ordre de quelques centaines de nanomètres à quelques microns, voire davantage.

Dans cet exemple, la surface de transmission 3 comporte des zones non revêtues par des plots photoluminescents 6₁, 6₂, situées en regard d'une ou de plusieurs diodes électroluminescentes, définissant ainsi des pixels lumineux P_{B} destinés à émettre de la lumière bleue. Ces pixels P_{B} peuvent présenter une taille sensiblement égale à celles des pixels lumineux P_{G}, P_{R} comportant des plots photoluminescents 6₁, 6₂. En variante, les zones destinées à former des pixels bleus peuvent comporter des plots photoluminescents dont les particules photoluminescentes sont adaptées à émettre une lumière bleue de longueur d'onde différente de celle de la lumière bleue émise par les diodes. A titre d'exemple, les diodes peuvent émettre à une longueur d'onde de 450nm environ et les particules photoluminescentes peuvent émettre à une longueur d'onde de 480nm environ.

La figure 1E illustre une étape de dépôt conforme d'une couche mince 9 en au moins un matériau réfléchissant, par exemple en au moins un matériau métallique. La couche mince 9 peut ainsi être déposée par dépôt chimique en phase vapeur (*Chemical Vapor Deposition,* en anglais), par exemple par dépôt de couche mince atomique (*Atomic Layer Deposition,* en anglais), voire par dépôt physique en phase vapeur (*Physical Vapor Deposition,* en anglais), par exemple par faisceau d'électrons, par pulvérisation cathodique (*Sputtering,* en anglais), ou autre. Par dépôt conforme, on entend le dépôt d'une couche mince sur les plots photoluminescents 6 de sorte qu'elle s'étende localement de manière sensiblement parallèle à la surface qu'elle recouvre. La couche mince déposée de manière conforme présente une épaisseur sensiblement homogène. L'épaisseur locale peut toutefois varier entre une valeur minimale au niveau par exemple d'une surface sensiblement orthogonale au plan XY et une valeur maximale au niveau par exemple d'une surface sensiblement parallèle au plan XY. A titre purement illustratif, pour un dépôt conforme d'une couche mince de 200nm, l'épaisseur de la couche peut varier entre une valeur de 100nm au niveau des flancs latéraux 8 des plots 6 et une valeur de 200nm au niveau de la surface de transmission 3 et des surfaces supérieures 7 des plots 6.

La couche mince 9 peut être formée d'un même matériau réfléchissant ou d'une pluralité de différents matériaux déposés les uns sur les autres. Les matériaux réfléchissants peuvent être choisis parmi l'aluminium, l'argent, le platine, ou tout autre matériau adapté. La couche mince 9 présente une épaisseur moyenne sensiblement homogène, qui peut être comprise entre 10nm et 500nm, et de préférence entre 50nm et 300nm, par exemple égale à 100nm environ au niveau des flancs latéraux 8 des plots 6.

La couche mince 9 recouvre les différents plots photoluminescents 6₁, 6₂ ainsi que la surface de transmission 3 non revêtue par les plots 6₁, 6₂. Ainsi, elle recouvre continûment les flancs latéraux 8₁, 8₂ et les surfaces supérieures 7₁, 7₂ des premiers et deuxièmes plots photoluminescents 6₁, 6₂, ainsi que la surface de transmission 3 située tant entre deux pixels lumineux adjacents comportant des blocs photoluminescents, i.e. ici des pixels verts P_{G} et rouges P_{R}, qu'au niveau des pixels lumineux ne comportant pas de plot photoluminescent, i.e. ici des pixels bleus P_{B}.

La figure 1F illustre une étape de formation de parois réfléchissantes 10₁, 10₂ recouvrant les flancs latéraux 8₁, 8₂ des plots photoluminescents 6₁, 6₂, par gravure localisée de la couche mince 9.

Ainsi, on grave les parties de la couche mince réfléchissante 9 non situées au contact des flancs latéraux 8₁, 8₂ des plots photoluminescents 6₁, 6₂. On supprime ainsi les parties de la couche mince 9 qui recouvrent les surfaces supérieures 7₁, 7₂ des plots photoluminescents 6₁, 6₂, et on supprime celles qui recouvrent les zones de la surface de transmission 3 définissant les pixels bleus P_{B}. Ainsi, on rend libre les surfaces supérieures 7₁, 7₂, ainsi que la surface de transmission 3 recouverte par la couche mince 9. Par rendre libre, on entend que les surfaces ne sont pas recouvertes par une couche. Les parties de la couche mince 9 situées sur la surface de transmission 3 entre deux pixels lumineux adjacents P_{G}, P_{R} comportant des blocs photoluminescents sont également supprimées. Ainsi, les flancs latéraux 8 des plots 6 sont recouverts par les parois réfléchissantes 10. Autrement dit, les parois réfléchissantes 10 reposent sur les flancs latéraux, les recouvrent continûment en étant à leur contact.

Cette étape de gravure peut être effectuée par gravure sèche, par exemple par gravure par plasma (RIE, ICP...). La gravure sèche étant fortement anisotrope, seules restent les parties de la couche mince réfléchissante 9 recouvrant les flancs latéraux 8₁, 8₂ des plots photoluminescents 6₁, 6₂, formant ainsi des parois réfléchissantes 10₁, 10₂ qui entourent les plots photoluminescents 6₁, 6₂ dans un plan parallèle au plan XY.

La couche de la surface de transmission 3 peut assurer une fonction d'arrêt à la gravure sèche du métal, permettant ainsi de préserver l'intégrité des diodes électroluminescentes. Elle peut ainsi être une face d'une couche de planarisation en matériau organique ou minéral, voire une couche de passivation en un matériau diélectrique, par exemple en oxyde de silicium (par exemple SiO₂), en nitrure de silicium (par exemple Si₃N₄), ou en oxynitrure de silicium (SiON).

Ainsi, le procédé de fabrication selon ce premier mode de réalisation permet d'obtenir un dispositif optoélectronique présentant une résolution élevée ainsi qu'un fort contraste. En effet, en utilisant une résine photosensible contenant des particules photoluminescentes et avantageusement des boîtes quantiques, il est possible de former les plots photoluminescents directement par photolithographie. On peut ainsi obtenir une matrice de plots photoluminescents de haute résolution, en évitant le recours à des techniques alternatives telles que le dépôt localisé de gouttes contenant des particules photoluminescentes. De telles techniques présentent des inconvénients notamment liés au contrôle de la taille des gouttes, l'alignement de l'organe de dispense de gouttes vis-à-vis des pixels lumineux etc... qui ne permettent pas d'obtenir la résolution recherchée. De plus, la formation de parois réfléchissantes par dépôt conforme puis gravure localisée permet d'obtenir un fort contraste dans la mesure où un rayonnement lumineux associé à un pixel ne peut atteindre le bloc photoluminescent d'un pixel voisin.

Les figures 2A à 2H illustrent un procédé de fabrication d'un dispositif optoélectronique 1 à diodes électroluminescentes selon un deuxième mode de réalisation.

La figure 2A illustre une étape de fourniture d'une matrice de diodes électroluminescentes suivie d'une étape de dépôt d'une première résine photosensible 5₁ comportant des premières particules photoluminescentes. Ces étapes sont identiques ou similaires à celles explicitées en référence à la fig.1A et ne sont pas décrites plus en détail.

La figure 2B illustre une étape de formation de premiers plots photoluminescents 6₁ par photolithographie de la première résine photosensible 5₁. Cette étape est également similaire ou identique à celle décrite en référence à la fig.lB.

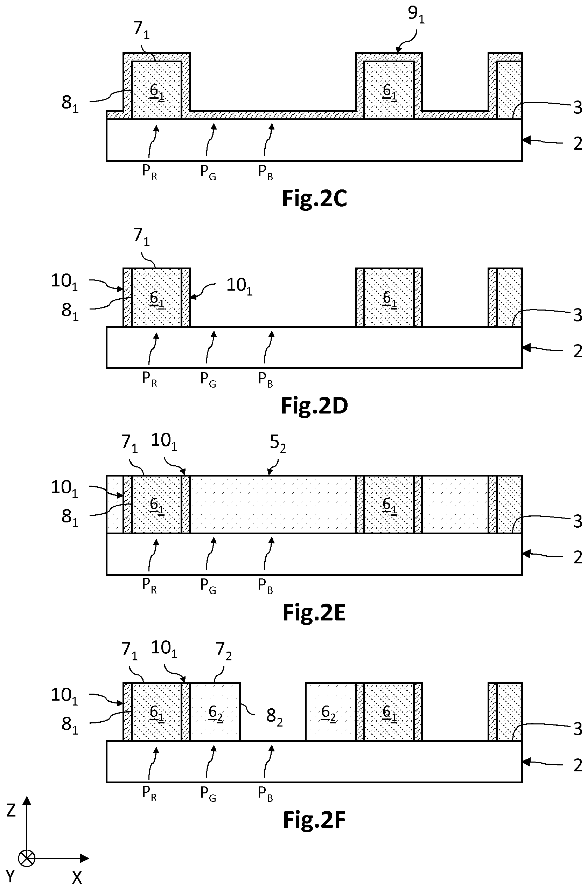

La figure 2C illustre une étape de dépôt conforme d'une première couche mince 9₁ en au moins un matériau réfléchissant. A la différence du premier mode de réalisation, la première couche mince réfléchissante 9₁ est déposée alors que les deuxièmes plots photoluminescents 6₂ ne sont pas encore formés.

La première couche mince 9₁ peut ainsi être déposée par l'une des techniques mentionnées précédemment. Elle peut être formée d'un même matériau réfléchissant ou d'une pluralité de différents matériaux déposés les uns sur les autres, et présente une épaisseur sensiblement constante, par exemple égale à 100nm environ.

Elle recouvre les premiers plots photoluminescents 6₁ ainsi que la surface de transmission 3 non revêtue par les premiers plots 6₁. Ainsi, elle recouvre continûment les flancs latéraux 8₁ et la surface supérieure 7₁ des premiers plots photoluminescents 61, ainsi que les zones de la surface de transmission 3 destinées à former les autres pixels lumineux, i.e. ici les pixels verts P_{G} et bleus P_{B}.

La figure 2D illustre une étape de formation de premières parois réfléchissantes 10₁, recouvrant les flancs latéraux 8₁ des premiers plots photoluminescents 61, par gravure localisée de la première couche mince 9₁.

Ainsi, on grave les parties de la couche mince 9₁ non situées au contact des flancs latéraux 8₁ des premiers plots photoluminescents 6₁. On supprime ainsi les parties de la couche mince 9 qui recouvrent les surfaces supérieures 7₁ des premiers plots photoluminescents 6₁, et on supprime celles qui recouvrent les zones de la surface de transmission 3 définissant les pixels verts P_{G} et bleus P_{B}.

Cette étape de gravure peut être effectuée par gravure sèche, par exemple par l'une des techniques citées précédemment. La gravure sèche étant fortement anisotrope, seules restent les parties de la première couche mince 9₁ recouvrant les flancs latéraux 8₁ des premiers plots photoluminescents 6₁, formant ainsi des premières parois réfléchissantes 10₁ qui entourent les premiers plots photoluminescents 6₁ dans un plan parallèle au plan XY.

La figure 2E illustre une étape de dépôt d'une deuxième résine photosensible 5₂ sur la surface de transmission 3. Elle peut être déposée par l'une des techniques mentionnées précédemment, de manière à recouvrir la surface de transmission 3 non revêtue par les premiers plots photoluminescents 6₁. Elle vient ainsi au contact des parois réfléchissantes 10₁ des premiers plots 6₁, et présente dans cet exemple une épaisseur sensiblement égale à celle des premiers plots photoluminescents 6₁. La deuxième résine photosensible 5₂ comporte des deuxièmes particules photoluminescentes, ici des boîtes quantiques, similaires ou identiques à celles décrites dans le premier mode de réalisation.

La figure 2F illustre une étape de formation de deuxièmes plots photoluminescents 6₂ par photolithographie de la deuxième résine photosensible 5₂. Dans cet exemple, ils sont positionnés sur la surface de transmission 3 au niveau de pixels destinés à émettre une lumière verte P_{G}.

A la différence du premier mode de réalisation, au moins un deuxième plot photoluminescent 6₂, et ici chaque deuxième plot photoluminescent 6₂ est situé contre un premier plot photoluminescent 6₁ de manière à être au contact de la première paroi réfléchissante 10₁ correspondante. Il est ici au contact d'au moins une première paroi réfléchissante 10₁, mais comporte au moins une partie libre de flanc latéral 8₂, c'est-à-dire une partie n'étant pas au contact d'une première paroi réfléchissante 10₁.

Les deuxièmes plots photoluminescents 6₂ sont distincts les uns des autres et sont également distincts des premiers plots photoluminescents 6₁. Chaque deuxième plot 6₂ est cependant séparé optiquement et structurellement du premier plot 6₁ contre lequel il est situé par la première paroi réfléchissante 10₁. Ainsi, le rayonnement lumineux de luminescence émis par les premières particules photoluminescentes ne peut être transmis dans le deuxième plot photoluminescent 6₂ adjacent, ni celui des deuxièmes particules photoluminescentes être transmis dans le premier plot photoluminescent 6₁ adjacent.

La figure 2G illustre une étape de dépôt d'une deuxième couche mince 9₂ en un matériau réfléchissant. La deuxième couche mince 9₂ peut être formée d'un ou plusieurs matériaux identiques à celui ou ceux de la première couche mince 9₁. De préférence, la deuxième couche mince 9₂ est identique, en termes de matériau et d'épaisseur, à la première couche mince 9₁.

La deuxième couche mince 9₂ est déposée de manière à recouvrir les premiers et deuxièmes plots photoluminescents 6₁, 6₂ ainsi que la surface de transmission 3 non revêtue par les plots photoluminescents 6₁, 6₂. Ainsi, elle recouvre continûment les surfaces supérieures 7₁, 7₂ des premiers et deuxièmes plots photoluminescents 6₁, 6₂, les flancs latéraux 8₂ des deuxièmes plots photoluminescents 6₂, ainsi que la première paroi réfléchissante 10₁ des premiers plots photoluminescents 6₁. Elle recouvre également les zones de la surface de transmission 3 destinées à former les pixels bleus P_{B}.

La figure 2H illustre une étape de formation, par gravure localisée de la deuxième couche mince 9₂, de deuxièmes parois réfléchissantes 10₂ recouvrant les flancs latéraux 8₂ des deuxièmes plots photoluminescents 6₂ qui ne sont pas au contact d'une première paroi réfléchissante 10₁. Ainsi, on grave les parties de la deuxième couche mince 9₂ non situées au contact des flancs latéraux 8₂ des deuxièmes plots photoluminescents 6₂. On supprime ainsi les parties de la couche mince 9₂ qui recouvrent les surfaces supérieures 7₁, 7₂ des premiers et deuxièmes plots photoluminescents 6₁, 6₂, et on supprime celles qui recouvrent les zones de la surface de transmission 3 définissant les pixels bleus P_{B}.

Cette étape de gravure peut être effectuée par gravure sèche, par exemple par l'une des techniques citées précédemment. La gravure sèche étant fortement anisotrope, seules restent les parties de la deuxième couche mince 9₂ recouvrant des flancs latéraux 8₂ des deuxièmes plots photoluminescents 6₂, formant ainsi des deuxièmes parois réfléchissantes 10₂. Alors que chaque première paroi réfléchissante 10₁ entoure continûment, dans un plan parallèle au plan XY, le premier plot photoluminescent 6₁ correspondant, chaque deuxième paroi réfléchissante 10₂ n'est au contact que d'une partie des flancs latéraux 8₂ du deuxième plot photoluminescent 6₂ correspondant. Il en ressort qu'une partie de la première paroi réfléchissante 10₁ est recouverte par une partie de la deuxième paroi réfléchissante 10₂, se traduisant par une épaisseur locale accrue de matériau réfléchissant.

Ainsi, le procédé selon le deuxième mode de réalisation permet d'obtenir un dispositif optoélectronique à plus haute résolution encore, dans la mesure où les premiers et deuxièmes plots photoluminescents 6₁, 6₂ situés les uns contre des autres ne sont séparés mutuellement que par une simple paroi réfléchissante dont l'épaisseur peut être inférieure à 500nm, par exemple égale à 100nm environ, voire moins. On est ainsi en mesure d'augmenter la résolution du dispositif optoélectronique, tout en maintenant un fort contraste entre les pixels.

Selon une variante illustrée sur la figure 3A, les pixels lumineux sont agencés de manière à former une matrice de Bayer, c'est-à-dire de manière à former une répétition géométrique d'un ensemble de plusieurs pixels lumineux adaptés à émettre à des longueurs d'onde différentes, par exemple deux pixels verts P_{G}, d'un pixel rouge P_{R} et d'un pixel bleu P_{B}, agencés de manière adjacente deux à deux.

Dans cet exemple, un même pixel vert P_{G} est adjacent de quatre pixels rouges P_{R} différents. Plus précisément, un même deuxième plot photoluminescent 6₂ adapté à convertir en lumière verte la lumière d'excitation bleue est bordé par quatre premiers plots photoluminescents 6₁ distincts les uns des autres et adaptés à convertir la lumière d'excitation bleue en lumière rouge. Chaque deuxième plot 6₂ est ainsi au contact des premières parois réfléchissantes 10₁ des quatre premiers plots 6₁ adjacents.

Ainsi, cette variante du procédé selon le deuxième mode de réalisation ne comporte pas d'étape de formation de deuxièmes parois réfléchissantes 10₂ recouvrant les flancs latéraux 8₂ des deuxièmes plots 6₂. En effet, lors du dépôt de la deuxième résine photosensible 5₂, celle-ci remplit les espaces formées entre les premiers plots photoluminescents 6₁, et plus précisément les espaces formés entre les premières parois réfléchissantes 10₁ en vis-à-vis les unes des autres. La deuxième résine photosensible 5₂ est ensuite supprimée par photolithographie dans les zones destinées à former des pixels lumineux bleus P_{B}. Les deuxièmes plots photoluminescents 6₂ ainsi formés sont donc au contact de parois réfléchissantes 10₁ de plusieurs premiers plots photoluminescents 6₁ voisins. Ils sont donc délimités latéralement, dans le plan XY, par les premières parois réfléchissantes 10₁.

D'autres agencements des pixels lumineux sont bien entendu possibles. Ainsi, dans l'exemple de la figure 3B, suivant l'axe X, les premiers plots photoluminescents 6₁ sont espacés deux à deux soit par un deuxième plot photoluminescent 6₂ soit par une zone de la surface de transmission 3 destinée à former un pixel bleu P_{B}.

Selon une autre variante illustrée sur la figure 3B, les parois réfléchissantes 10₁ sont inclinées par rapport au plan XY. Par inclinées, on entend que les parois réfléchissantes 10₁ présentent un angle d'inclinaison différent de 90° par rapport au plan XY. Cet angle d'inclinaison peut ainsi être inférieur strictement à 90° et supérieur ou égal à une valeur d'inclinaison maximale non nulle, par exemple égale à 20° environ. Elles sont ici sensiblement planes et présentent un angle local d'inclinaison sensiblement constant. Les premiers plots photoluminescents 6₁, de préférence adaptés à convertir la lumière d'excitation dans le rouge, présentent une forme pyramidale tronquée, c'est-à-dire que la taille de la surface supérieure 7₁ est inférieure à celle de la base du plot au contact de la surface de transmission 3.

En revanche, les deuxièmes phots photoluminescents 6₂, de préférence adaptés à convertir la lumière d'excitation dans le vert, présentent une forme évasée, dans le sens où la taille de la surface supérieure 7₂ est supérieure à celle de la base. Ils présentent ainsi une forme de pyramide inversée tronquée. Le fait que les deuxièmes plots photoluminescents 6₂ aient une forme évasée vers l'extérieur permet d'améliorer l'extraction lumineuse du rayonnement de luminescence. Il permet ainsi de limiter l'éventuelle réabsorption du rayonnement de luminescence par les mêmes particules photoluminescentes, ce qui est particulièrement avantageux lorsque celles-ci sont adaptées à émettre une lumière de luminescence dans le vert.

En variante, les parois réfléchissantes 10₁, 10₂ peuvent ne pas être planes, mais peuvent présenter une forme courbe, en particulier lorsque les premiers plots photoluminescents 6₁ présentent des flancs latéraux 8₁ sensiblement courbes. Par courbe, on entend notamment une surface qui ne présente pas de zone plane, ou qui est formée d'une succession de zones planes inclinées deux à deux. Il est alors possible de limiter la gravure partielle des parois réfléchissantes 10₁, 10₂ lors de l'étape de gravure sèche des couches minces réfléchissantes 9₁, 9₂, tout en optimisant l'extraction lumineuse et en limitant la réabsorption de la lumière de luminescence des deuxièmes plots photoluminescents 6₂.

D'une manière générale, les diodes électroluminescentes peuvent présenter différents types de structures. Les figures 4A et 4B illustrent un exemple de diodes électroluminescentes 4 de type filaire, ici en configuration dite cœur-coquille.

En référence à la figure 4A, le dispositif optoélectronique comporte une puce optoélectronique 2 dans laquelle se situe la matrice de diodes électroluminescentes 4. Chaque pixel lumineux comporte ainsi une pluralité de diodes électroluminescentes 4 filaires. Les diodes électroluminescentes 4 peuvent être uniformément réparties dans chaque pixel lumineux, et former des ensembles de diodes électriquement distincts les uns des autres. Ainsi, chaque ensemble de diodes appartient à un pixel lumineux, qui peut être activé indépendamment des autres ensembles de diodes. Dans un même ensemble, les diodes électroluminescentes 4 sont connectées en parallèle, de sorte à émettre de manière simultanée lorsque le pixel correspondant est activé.

Les diodes électroluminescentes 4 reposent sur une couche support 25, par exemple un substrat de croissance. Dans le cas où le substrat de croissance 25 est électriquement isolant, des lignes électriques (non représentées) peuvent être présentes à l'intérieur du substrat 25 pour permettre la polarisation des différents pixels de diodes électroluminescentes 4. Dans le cas d'un substrat de croissance 25 électriquement conducteur, par exemple réalisé à base de silicium, des tranchées isolantes (non représentées) peuvent être prévues pour isoler électriquement les pixels les uns des autres. Par ailleurs, la couche support 25 peut être fixée et électriquement connectée à une puce de commande (non représentée) adaptée à assurer la commande électrique du dispositif optoélectronique.

Les diodes électroluminescentes 4 sont revêtues d'au moins une couche d'espacement 12 dont la face opposée à la couche support forme la surface de transmission 3. La couche d'espacement 12 est transparente au rayonnement lumineux émis par les diodes électroluminescentes 4. Elle peut être formée d'une couche de passivation, réalisée en un matériau diélectrique, et éventuellement d'une couche de planarisation. Le matériau diélectrique peut être choisi parmi un oxyde, un nitrure voire un oxynitrure de silicium. D'autres matériaux peuvent également convenir. La couche de planarisation peut être formée d'un matériau organique ou minéral, tel que le silicone ou le PMMA. La couche d'espacement présente une épaisseur supérieure à la dimension longitudinale, suivant l'axe Z, des diodes électroluminescentes 4, de manière à les recouvrir uniformément.

La figure 4B illustre un exemple de diode électroluminescente 4 appartenant à un même pixel lumineux, de type filaire en configuration cœur/coquille. La diode électroluminescente 4 présente une forme tridimensionnelle allongée et s'étend longitudinalement suivant un axe parallèle à l'axe Z. Dans cet exemple, elle comporte une première portion dopée 21, par exemple de type n, sous la forme d'un fil qui s'étend longitudinalement à partir d'un plot de nucléation 24 qui repose sur une face avant d'un substrat de croissance 25. Un masque de croissance 26 en un matériau diélectrique recouvre la face avant du substrat 25 et comporte une ouverture débouchant sur le plot de nucléation 24. Les plots de nucléation 24 peuvent être des plots distincts les uns des autres, voire différentes zones d'une même couche mince continue. Une partie supérieure de la première portion dopée 21 est recouverte, au niveau de sa bordure supérieure et de sa bordure latérale, par une ou plusieurs couches formant une zone active 23 qui comporte au moins un puits quantique. La zone active 23 est elle-même recouverte par une couche formant une deuxième portion dopée 22, ici de type p. Les diodes électroluminescentes 4 sont ici de nanofils ou microfils en configuration cœur/coquille, la portion dopée 21 et la portion dopée 22 forment respectivement le cœur et la coquille du fil.

Les diodes électroluminescentes 4 d'un même pixel lumineux sont ici connectées électriquement en parallèle. La face arrière du substrat 25, ici électriquement conducteur, est revêtue d'une première électrode de polarisation 27, et les portions dopées 22 sont recouvertes d'une couche continue formant une deuxième électrode de polarisation 28. Enfin, la couche d'espacement 12 recouvre entièrement les diodes électroluminescentes 4. Elle présente une face supérieure, ici sensiblement plane, qui forme la surface de transmission 3 de la matrice de diodes électroluminescentes 4.

La figure 4C illustre un autre exemple de diode électroluminescente 4 appartenant à un même pixel lumineux, de type filaire en configuration axiale. Dans cet exemple, le fil est formé d'un empilement de la première portion dopée 21, de la zone active 23, et de la deuxième portion dopée 22, qui s'étend suivant un axe longitudinal parallèle à l'axe Z. A la différence de la configuration cœur/ coquille, la zone active 23 ne recouvre sensiblement que la bordure supérieure de la portion dopée 21, et la portion dopée 22 ne recouvre sensiblement que la bordure supérieure de la zone active 23. Comme précédemment, le fil s'étend longitudinalement à partir d'un plot de nucléation 24 qui repose sur une face avant d'un substrat de croissance 25. Le masque de croissance 24 recouvre la face avant du substrat 25 et comporte une ouverture débouchant sur le plot de nucléation 24. La couche d'espacement recouvre la bordure latérale du fil, et est traversée par la deuxième électrode de polarisation 28 qui vient au contact de la bordure supérieure de la deuxième portion dopée 22. La couche d'espacement 12 présente une face supérieure qui forme la surface de transmission 3.

A titre purement illustratif, les diodes électroluminescentes 4 peuvent être réalisées à base de GaN et être adaptées à émettre un rayonnement d'excitation dans le bleu. Elles peuvent présenter des dimensions transversales comprises entre 10nm et 10µm, par exemple comprises entre 100nm et 5µm. La hauteur est supérieure aux dimensions transversales, par exemple 2 fois, 5 fois, et de préférence au moins 10 fois supérieure, et peut être égale à 10µm environ.

La figure 5 illustre un dispositif optoélectronique dans lequel les diodes électroluminescentes 4 présentent une structure en mesa. Dans cet exemple, chaque pixel lumineux comporte une unique diode électroluminescente 4 qui peut être activée indépendamment des autres diodes 4.

Les diodes électroluminescentes 4 sont formées chacune d'un empilement d'une première portion dopée 31, ici de type n, et d'une deuxième portion dopée 32, ici de type p, entre lesquelles est située une zone active 33. Elles forment des structures en mesa sensiblement coplanaires les unes aux autres. Cette structure de diodes électroluminescentes 4 est similaire ou identique à celle décrite dans le document EP2960940, dont le texte est considéré comme faisant partie intégrante de la présente description. Par structure en mesa, on entend une structure formée d'un empilement de portions semiconductrices 31, 32, 33 situées en saillie au-dessus d'un substrat de croissance à la suite d'une étape de gravure. Les structures en mesa sont sensiblement coplanaires dans le sens où les premières portions dopées 31 des diodes électroluminescentes 4 sont respectivement coplanaires. Il en est de même pour les zones actives 33 et les deuxièmes portions dopées 32.

Chaque diode électroluminescente 4 présente une première portion dopée 31 dont une surface opposée à la zone active 33 est une surface par laquelle est émis le rayonnement lumineux de la diode 4. Les flancs latéraux de la première portion dopée 31 et de la deuxième portion dopée 32, ainsi que ceux de la zone active 33, sont recouverts d'une couche diélectrique 34, à l'exception d'une surface de décrochement 35 de la première portion dopée 31.

Les diodes électroluminescentes 4 sont séparées les unes des autres par des éléments latéraux 36 de connexion électrique qui s'étendent suivant l'axe Z entre les diodes. Chaque diode électroluminescente 4 est ainsi associée à un élément latéral 36 de connexion qui vient au contact électrique de la surface de décrochement 35 de la première portion dopée 31, permettant d'appliquer un potentiel électrique déterminée à la première portion dopée 31. Cet élément latéral 36 de connexion est cependant électriquement isolé des diodes 4 adjacentes par les couches diélectriques 34 de celles-ci.

La puce optoélectronique 2 comporte dans cet exemple une couche 37 dite de raccord électrique, qui participe à former une couche support, la couche 37 permettant le contact électrique entre une puce de commande (non représentée) et les éléments latéraux 36 de connexion électrique, et des portions 38 de connexion électrique situées au contact des deuxièmes portions dopées 32. La couche de raccord 37 comporte ainsi des plots de connexion 39 électriquement isolés les uns des autres par un matériau diélectrique. Ainsi, la puce de commande peut appliquer un potentiel électrique à l'une et/ ou l'autre des diodes électroluminescentes 4, et ainsi les activer indépendamment les unes des autres.

La couche d'espacement 12 comporte ici une couche de passivation en un matériau diélectrique recouvre la face d'émission des premières portions dopées 31 des diodes électroluminescentes 4, ainsi que les éléments latéraux 36 de connexion, éventuellement complétée d'une couche de planarisation. La face de la couche d'espacement 12 opposée aux diodes électroluminescentes 4 forme la surface de transmission 3 de la matrice de diodes.

A titre purement illustratif, les diodes électroluminescentes 4 peuvent être réalisées à base de GaN et être adaptées à émettre un rayonnement lumineux dans le bleu. Elles peuvent présenter une épaisseur comprise entre 100nm et 50µm, et les dimensions latérales peuvent être comprises entre 500nm et quelques centaines de microns, et de préférence sont inférieures à 50µm, de préférence à 30µm, et peuvent être égales à 10µm voire à 5µm.

En variante aux premier et deuxième modes de réalisation dans lesquels les plots photoluminescents 6 sont directement réalisés sur une surface d'émission 3 d'une matrice de diodes électroluminescentes, les étapes de formation des plots photoluminescents 6 et des parois réfléchissantes 10 peuvent être effectuées sur une surface dite support d'une plaque transparente au rayonnement lumineux émis par les diodes électroluminescentes, la plaque transparente étant ensuite rapportée et fixée sur la matrice de diodes électroluminescentes, par exemple sur la couche d'espacement. Le procédé selon cette variante est alors similaire à ceux des premier et deuxième modes de réalisation décrits précédemment, la surface d'émission 3 étant alors une surface de la plaque transparente. La plaque transparente peut être réalisée en verre, notamment en verre borosilicate, par exemple du pyrex ou du saphir, ou en tout autre matériau adapté. Elle présente une épaisseur autorisant sa manipulation et donc son report sur les diodes. La fixation de la plaque transparente sur la matrice de diodes électroluminescentes, par exemple sur la couche d'espacement mentionnée précédemment, peut être réalisée par tout moyen, par exemple par collage en utilisant une colle transparente aux rayonnements lumineux émis par les diodes. Après l'étape de report de la plaque transparente sur la matrice de diodes électroluminescentes, les plots photoluminescents sont situés chacun en vis-à-vis d'au moins une diode électroluminescente.

Les figures 6A à 6I illustrent un procédé de fabrication d'un dispositif optoélectronique 1 à diodes électroluminescentes selon un troisième mode de réalisation, qui se distingue des premier et deuxième modes de réalisation essentiellement en ce que les diodes sont de type filaire et sont situées à l'intérieur de plots de résine photosensible, dont certains ou tous sont photoluminescents. Par situées à l'intérieur, on entend que le plot de résine photosensible entoure chacune des diodes électroluminescentes correspondantes dans le plan XYet les recouvre suivant l'axe Z. Les diodes électroluminescentes sont donc au contact de la résine photosensible du plot et n'en sont pas espacés par la couche d'espacement comme dans les premier et deuxième modes de réalisation.

La figure 6A illustre une étape de fourniture d'une matrice de diodes électroluminescentes de type filaire, et de préférence en configuration cœur/coquille. Les diodes électroluminescentes 4 présentent ici une structure identique ou similaire à celle représentée sur la fig.4B, à l'exception de la couche d'espacement 12. Elles se présentent ainsi sous la forme d'une structure tridimensionnelle allongée, qui s'étend suivant un axe longitudinal parallèle à l'axe Z à partir de la surface d'une couche support, par exemple le substrat de croissance 25.

Les diodes électroluminescentes 4 sont agencées sur la couche support 25 par ensembles de diodes électroluminescentes destinés à former des pixels lumineux de différentes couleurs d'émission, par exemple ici des pixels bleus P_{B}, rouges P_{R}, et verts P_{G}. Ainsi, de préférence, les diodes d'un même ensemble, et donc d'un même pixel lumineux, sont connectées électriquement en parallèle, et chaque ensemble de diodes est électriquement indépendant des autres ensembles. A titre illustratif, les diodes électroluminescentes 4 peuvent présenter une hauteur égale à 10µm environ. Dans cet exemple, elles sont réalisées à base de GaN et sont adaptées à émettre une lumière d'excitation bleue.

La figure 6B illustre une étape de dépôt sur une surface support 3', ici la surface de la couche support 25, d'une première résine photosensible 5₁ comportant des premières particules photoluminescentes. La résine photosensible 5₁ est au contact et recouvre la surface 3' de la couche support 25, et est au contact et recouvre chaque diode électroluminescente 4 au niveau de sa surface d'émission. Elle s'étend ainsi, dans un plan parallèle au plan XY, entre chacune des diodes électroluminescentes 4, et présente une épaisseur supérieure à la hauteur des diodes électroluminescentes 4. A titre illustratif, la première résine photosensible 5₁ peut présenter une épaisseur égale à 20µm environ. Les premières particules photoluminescentes peuvent être ici adaptées à convertir en une lumière rouge la lumière d'excitation bleue émise par les diodes électroluminescentes 4. Elles sont ici des boîtes quantiques, dont la taille moyenne est inférieure à 50nm.

La figure 6C illustre une étape de formation de premiers plots photoluminescents 6₁ par photolithographie de la première résine photosensible 5₁. Les premiers plots photoluminescents 6₁ sont localisés au niveau de zones destinées à former des pixels lumineux rouges P_{R}. Chaque premier plot 6₁ recouvre et s'étend ainsi entre les diodes électroluminescentes 4 du pixel P_{R} correspondant. Autrement dit, les diodes 4 des pixels P_{R} sont situées à l'intérieur des premiers plots 6₁, et n'en sont pas situées à distance comme dans les premier et deuxième modes de réalisation décrits précédemment. A titre illustratif, les premiers plots 6₁ présentent une épaisseur sensiblement égale à 20µm et une largeur sensiblement égale à 10µm. Les premiers plots photoluminescents 6₁ présentent une largeur telle que chaque premier plot 6₁ s'étend au niveau du pixel lumineux P_{R} correspondant, et ne s'étend pas sur les zones destinées à former les pixels lumineux voisins d'autres couleurs P_{B} et P_{G}. Les zones destinées à former des pixels lumineux d'autres couleurs, par exemple ici bleus P_{B} et verts P_{G}, ne comportent pas de premiers plots photoluminescents 6₁.

La figure 6D illustre une étape de dépôt d'une deuxième résine photosensible 5₂ comportant des deuxièmes particules photoluminescentes. Celles-ci sont différentes des premières particules photoluminescentes dans le sens où leur spectre d'émission est différent de celui des premières particules photoluminescentes. Dans cet exemple, elles sont adaptées à convertir en une lumière verte la lumière d'excitation bleue émise par les diodes électroluminescentes 4. Elles sont ici des boîtes quantiques, dont la taille moyenne est inférieure à 50nm. La deuxième résine 5₂ est au contact et recouvre la surface 3' de la couche support 25, et est au contact et recouvre chaque diode électroluminescente 4 non située dans les premiers plots 6₁. Elle s'étend ainsi, dans un plan parallèle au plan XY, entre les diodes électroluminescentes 4 situées au niveau des zones destinées à former des pixels lumineux bleus P_{B} et verts P_{G}, et présente une épaisseur supérieure à la hauteur des diodes électroluminescentes 4. A titre illustratif, la deuxième résine photosensible 5₂ peut présenter une épaisseur sensiblement égale à 20µm environ.

La figure 6E illustre une étape de formation de deuxièmes plots photoluminescents 6₂ par photolithographie de la deuxième résine photosensible 5₂. Les deuxièmes plots 6₂ sont localisés au niveau de zones destinées à former des pixels lumineux verts P_{G}. Chaque deuxième plot 6₂ recouvre ainsi les diodes électroluminescentes 4 du pixel P_{G} correspondant, et s'étend entre les diodes 4 en étant au contact de celles-ci. Autrement dit, les diodes 4 des pixels P_{G} sont situées à l'intérieur des deuxièmes plots 6₂. A titre illustratif, les deuxièmes plots 6₂ présentent une épaisseur sensiblement égale à 20µm et une largeur sensiblement égale à 10µm. Les deuxièmes plots 6₂ présentent une largeur telle que chaque deuxième plot 6₂ s'étend au niveau du pixel lumineux P_{G} correspondant, et ne s'étend pas sur les zones destinées à former les pixels lumineux voisins bleus P_{B}. Les zones destinées à former des pixels lumineux bleus P_{B} ne comportent pas de deuxièmes plots photoluminescents 6₂.

La figure 6F illustre une étape de dépôt d'une troisième résine photosensible 5₃ de sorte qu'elle recouvre les diodes situées dans des zones destinées à former des pixels bleus P_{B}. Elle vient au contact et recouvre la surface 3' de la couche support 25. La troisième résine photosensible 5₃ peut ou non comporter des troisièmes particules photoluminescentes différentes des premières et deuxièmes particules photoluminescentes. Dans le cas où elle ne comporte pas de particules photoluminescentes, le pixel lumineux P_{B} est adapté à émettre une lumière dont le spectre correspond à celui des diodes électroluminescentes. Dans cet exemple, elle comporte des troisièmes particules photoluminescentes, ici des boîtes quantiques dont la taille moyenne est inférieure à 50nm, adaptées à convertir la lumière d'excitation bleue émise par les diodes électroluminescentes 4 en une lumière bleue d'une autre longueur d'onde. A titre d'exemple, les diodes peuvent émettre à une longueur d'onde de 450nm environ et les troisièmes particules peuvent être adaptées à émettre une lumière de luminescence à 480nm environ. La troisième résine 5₃ est au contact et recouvre la surface de la couche support, et est au contact et recouvre chaque diode 4 non située dans les premiers et deuxièmes plots 6₁ et 6₂. Elle s'étend ainsi, dans un plan parallèle au plan XY, entre les diodes électroluminescentes 4 situées au niveau des zones destinées à former des pixels lumineux bleus P_{B}, et présente une épaisseur supérieure à la hauteur des diodes électroluminescentes 4. A titre illustratif, la troisième résine photosensible 5₃ peut présenter une épaisseur sensiblement égale à 20µm environ.

La figure 6G illustre une étape de formation de troisièmes plots 6₃, ici des plots photoluminescents, par photolithographie de la troisième résine photosensible 5₃. Les troisièmes plots 6₃ sont localisés au niveau de zones destinées à former des pixels lumineux bleus P_{B}. Chaque troisième plot 6₃ recouvre et s'étend entre les diodes 4 du pixel P_{B} correspondant, en étant au contact de celles-ci. Autrement dit, les diodes 4 des pixels P_{B} sont situées à l'intérieur des troisièmes plots 6₃. A titre illustratif, les troisièmes plots 6₃ présentent une épaisseur sensiblement égale à 20µm et une largeur sensiblement égale à 10µm. Les troisièmes plots 6₃ présentent une largeur telle que chaque troisième plot 6₃ s'étend au niveau du pixel lumineux bleu P_{B} correspondant.

La figure 6H illustre une étape de dépôt conforme d'une couche mince 9 en au moins un matériau réfléchissant, par exemple au moins un matériau métallique, de manière à recouvrir les premiers, deuxièmes et troisièmes plots 6₁, 6₂, 6₃. La couche mince revêt ainsi de manière continue les surfaces supérieures 7₁, 7₂, 7₃ et les flancs latéraux 8₁, 8₂, 8₃ des plots 6₁, 6₂, 6₃. Elle peut présenter une épaisseur sensiblement homogène, par exemple égale à 100nm environ au niveau des flancs latéraux 8 des plots 6.

La figure 6₁ illustre une étape de formation des parois réfléchissantes 10₁, 10₂, 10₃ recouvrant les flancs latéraux 8₁, 8₂, 8₃ par gravure localisée de la couche mince 9. Ainsi, on grave, ici par gravure sèche, les parties de la couche mince 9 qui recouvrent les surfaces supérieures 7₁, 7₂, 7₃. Il y a également gravure des parties de la couche mince 9 qui reposent sur la surface 3' de la couche support 25.

Ainsi, par le procédé de fabrication selon le troisième mode de réalisation, on est en mesure d'obtenir un dispositif optoélectronique dont les diodes électroluminescentes, de type filaire, sont situées à l'intérieur des plots de résine photosensible, dont au moins une partie des plots est photoluminescente. Une haute résolution peut être obtenue par le fait que les plots de résine photosensible sont réalisés par photolithographie et par le fait que les particules photoluminescentes sont des boîtes quantiques.

La figure 7 illustre une variante du procédé selon le troisième mode de réalisation dans lequel la couche mince réfléchissante 9 est déposée de manière à ce que son épaisseur au niveau des flancs latéraux 8₁, 8₂, 8₃ des plots 6₁, 6₂, 6₃ soit supérieure à la moitié de la distance qui sépare deux plots voisins dans le plan XY. Ainsi, lors de l'étape de dépôt de la couche mince 9, on obtient un contact entre les parois réfléchissantes 10 en regard l'une de l'autre de deux plots 6 voisins.

En variante de la figure 7 et du troisième mode de réalisation décrit précédemment, les parois réfléchissantes 10 peuvent être formées par dépôt électrochimique. Plus précisément, comme illustré sur les figures 6A-6G, on réalise les plots 6 de résine photosensible, qui reposent sur une surface 3' de la couche support 25. Une piste mince de croissance, réalisée en au moins un matériau métallique, par exemple en titane, cuivre, ou aluminium, est située sur la surface 3' de la couche support 25, et s'étend entre les plots 6 voisins deux à deux, de manière à entourer chacun des plots 6. Puis, en variante aux figures 6H et 6I, on réalise les parois réfléchissantes 10 par dépôt électrochimique d'un matériau réfléchissant, tel qu'un métal, par exemple du nickel, aluminium ou argent. Le métal croît alors à partir de la couche mince de croissance, et remplit l'espace délimité par les flancs latéraux 8 en regard les uns des autres. Le métal recouvre ainsi les flancs latéraux des plots 6 et forme les parois réfléchissantes. Le dispositif optoélectronique 1 est alors similaire à celui illustré sur la figure 7 en ce sens que les parois réfléchissantes 10 remplissent l'espace formé entre les plots 6 voisins. A titre illustratif, la distance entre deux plots 6 voisins peut être comprise entre 0,5µm et 5µm.

En variante au procédé selon le troisième mode de réalisation décrit précédemment, les premiers, deuxièmes, troisièmes plots photoluminescentes 6, ainsi que les parois réfléchissantes 10 correspondantes, peuvent être réalisées de manière successive. Plus précisément, de manière similaire au deuxième mode de réalisation, la formation des premiers plots photoluminescents 6₁ est effectuée, suivie de la formation des premières parois réfléchissantes 10₁, puis la formation des deuxièmes plots photoluminescents 6₂ est effectuée, suivie de la formation des deuxièmes parois réfléchissantes 10₂, et ainsi de suite.

Des modes de réalisation particuliers viennent d'être décrits. Différentes variantes et modifications apparaîtront à l'homme du métier. Ainsi, les diodes électroluminescentes peuvent être adaptées à émettre une lumière d'excitation dans une couleur autre que le bleu, et les différents plots photoluminescents peuvent être adaptés à convertir la lumière d'excitation dans d'autres couleurs que le rouge et le vert. De plus, les plots de résine photosensible peuvent ne pas comporter de particules photoluminescentes. Par ailleurs, d'une manière générale, les plots photoluminescents 6 peuvent présenter des dimensions, en épaisseur et/ ou en largeur, différentes les uns des autres. L'invention est telle que définie dans les revendications jointes

## Revendications

1. Procédé de réalisation d'un dispositif optoélectronique (1) comportant une matrice de diodes électroluminescentes (4) et une pluralité de plots photoluminescents (6₁, 6₂, 6₃...) situés chacun en vis-à-vis d'au moins une partie desdites diodes électroluminescentes (4), comportant les étapes suivantes :
∘ formation de ladite pluralité de plots photoluminescents (6₁, 6₂, 6₃...) par photolithographie d'au moins une résine photosensible (5₁, 5₂, 5₃...) contenant des particules photoluminescentes préalablement déposée sur une surface support (3 ; 3') ;
∘ formation de parois réfléchissantes (10₁, 10₂, 10₃...) recouvrant des flancs latéraux (8₁, 8₂, 8₃...) desdits plots photoluminescents (6₁, 6₂, 6₃...), par dépôt d'au moins une portion de couche mince (9₁, 9₂, 9₃...) sur les flancs latéraux (8₁, 8₂, 8₃...).

2. Procédé selon la revendication 1, dans lequel l'étape de formation des parois réfléchissantes (10₁, 10₂, 10₃) comporte un dépôt conforme d'au moins une couche mince (9₁, 9₂, 9₃) en un matériau réfléchissant de manière à recouvrir les plots photoluminescents (6₁, 6₂, 6₃), puis gravure localisée de la couche mince (9₁, 9₂, 9₃) déposée, de manière à rendre libre une surface dite supérieure (7₁, 7₂, 7₃) des plots photoluminescents (6₁, 6₂, 6₃) opposée à ladite surface support (3 ; 3').

3. Procédé selon la revendication 2, dans lequel les étapes de formation de la pluralité de plots photoluminescents (6₁, 6₂), et de formation des parois réfléchissantes (10₁, 10₂) comportent les étapes suivantes :
∘ formation d'une pluralité de premiers plots photoluminescents (6₁), par photolithographie d'une première résine photosensible (5₁) contenant des premières particules photoluminescentes préalablement déposée sur ladite surface support (3 ; 3') ;
∘ formation de premières parois réfléchissantes (10₁) recouvrant des flancs latéraux (8₁) desdits premiers plots photoluminescents (6₁) par dépôt conforme d'une couche mince réfléchissante (9₁) sur les premiers plots photoluminescents (6₁), puis gravure localisée de manière à rendre libre une surface supérieure (7₁) des premiers plots photoluminescents (6₁) ;
∘ formation d'une pluralité de deuxièmes plots photoluminescents (6₂), par photolithographie d'une deuxième résine photosensible (5₂) contenant des deuxièmes particules photoluminescentes préalablement déposée sur ladite surface support (3 ; 3'), les deuxièmes particules photoluminescentes étant différentes des premières particules photoluminescentes.

4. Procédé selon la revendication 3, comportant, à la suite de l'étape de formation de la pluralité de deuxièmes plots photoluminescents (6₂), une étape de :
∘ formation de deuxièmes parois réfléchissantes (10₂) recouvrant des flancs latéraux (82) desdits deuxièmes plots photoluminescents (6₂) par dépôt conforme d'une couche mince réfléchissante (9₂) sur les premiers et deuxièmes plots photoluminescents (6₁, 6₂), puis gravure localisée de manière à rendre libre la surface supérieure (7₁, 7₂) des premiers et deuxièmes plots photoluminescents (6₁, 6₂).

5. Procédé selon la revendication 3 ou 4, dans lequel chaque deuxième plot photoluminescent (6₂) est en contact d'au moins une première paroi réfléchissante (10₁),

6. Procédé selon l'une quelconque des revendications 2 à 5, dans lequel chaque première paroi réfléchissante (10₁ présente une épaisseur comprise entre 10nm et 500nm.

7. Procédé selon la revendication 1, dans lequel l'étape de formation de la pluralité de plots photoluminescents (6₁, 6₂, 6₃) comporte au moins une formation de plusieurs premiers plots photoluminescents (6₁) contenant des premières particules photoluminescentes suivie d'une formation de plusieurs deuxièmes plots photoluminescents (6₂) contenant des deuxièmes particules photoluminescentes différentes des premières particules photoluminescents, l'étape de formation des parois réfléchissantes (10₁, 10₂, 10₃) étant effectuée après les formations d'au moins les premiers et deuxièmes plots photoluminescents (6₁, 6₂).

8. Procédé selon la revendication 7, dans lequel les parois réfléchissantes (10₁, 10₂, 10₃) sont formées par dépôt électrochimique.

9. Procédé selon l'une quelconque des revendications 1 à 8, dans lequel les particules photoluminescentes sont des boîtes quantiques, et présentent une taille moyenne inférieure ou égale à 50nm.

10. Procédé selon l'une quelconque des revendications 1 à 9, dans lequel les diodes électroluminescentes (4) sont des éléments tridimensionnels allongés s'étendant longitudinalement de manière sensiblement orthogonale à un plan principal d'une couche support (25, 37).

11. Procédé selon l'une quelconque des revendications 10, dans lequel les diodes électroluminescentes (4) sont situées à l'intérieur des plots (6₁, 6₂, 6₃) de résine photosensible, dont au moins une partie des plots (6₁, 6₂, 6₃) sont des plots photoluminescents comportant des particules photoluminescentes.

12. Procédé selon l'une quelconque des revendications 1 à 10, dans lequel les plots photoluminescents (6₁, 6₂, 6₃) reposent sur une surface support (3), dite surface de transmission, formée par une couche d'espacement (12) recouvrant les diodes électroluminescentes (4).

13. Dispositif optoélectronique (1), comportant :
∘ une matrice de diodes électroluminescentes (4) reposant sur une couche support ;
∘ une pluralité de premiers plots photoluminescents (6₁), situés chacun en vis-à-vis d'au moins une partie desdites diodes électroluminescentes (4), formés chacun d'une première résine photosensible (5₁) comportant des premières particules photoluminescentes, ayant des flancs latéraux (8₁) recouverts par une portion de couche mince déposée formant une première paroi réfléchissante (10₁) ;
∘ une pluralité de deuxièmes plots photoluminescents (6₂), situés chacun en vis-à-vis d'au moins une partie desdites diodes électroluminescentes (4), formés chacun d'une deuxième résine photosensible (5₂) comportant des deuxièmes particules photoluminescentes différentes des premières particules photoluminescentes, ayant des flancs latéraux (8₂) recouverts par une portion de couche mince déposée formant une deuxième paroi réfléchissante (10₂), chaque deuxième plot photoluminescent (6₂) étant au contact d'une première paroi réfléchissante (10₁),

14. Dispositif optoélectronique (1) selon la revendication 13, dans lequel les diodes électroluminescentes (4) présentent une structure tridimensionnelle allongée suivant un axe longitudinal sensiblement orthogonal à la couche support (25, 37).

15. Dispositif optoélectronique (1) selon la revendication 13 ou 14, dans lequel les diodes électroluminescentes (4) sont situées à l'intérieur des plots photoluminescents (6₁, 6₂).

16. Dispositif optoélectronique (1) selon la revendication 13, dans lequel les diodes électroluminescentes (4) présentent une structure en mesa.

## Patentansprüche

1. Verfahren zur Herstellung einer optoelektronischen Vorrichtung (1), die eine Matrix von Elektrolumineszenzdioden (4) und eine Vielzahl von Fotolumineszenz-Pads (6₁, 6₂, 6₃...), die sich jeweils gegenüber mindestens einem Teil der Elektrolumineszenzdioden (4) befinden, umfasst, umfassend die folgenden Schritte:
∘ Bilden der Vielzahl von Fotolumineszenz-Pads (6₁, 6₂, 6₃...) durch Fotolithografie mindestens eines Fotolacks (5₁, 5₂, 5₃...), der Fotolumineszenzpartikel enthält und zuvor auf eine Trägerfläche (3; 3') abgeschieden wurde;
∘ Bilden reflektierender Wände (10₁, 10₂, 10₃...), die Seitenflanken (8₁, 8₂, 8₃...) der Fotolumineszenz-Pads (6₁, 6₂, 6₃...) abdecken, durch Abscheiden mindestens eines Dünnschichtabschnitts (9₁, 9₂, 9₃...) auf die Seitenflanken (8₁, 8₂, 8₃...).

2. Verfahren nach Anspruch 1, wobei der Schritt des Bildens der reflektierenden Wände (10₁, 10₂, 10₃) ein ebenmäßiges Abscheiden mindestens einer Dünnschicht (9₁, 9₂, 9₃) aus einem reflektierenden Material, um die Fotolumineszenz-Pads (6₁, 6₂, 6₃) abzudecken, umfasst, gefolgt von einem lokalisierten Ätzen der abgeschiedenen Dünnschicht (9₁, 9₂, 9₃), um eine sogenannte obere Fläche (7₁, 7₂, 7₃) der Fotolumineszenz-Pads (6₁, 6₂, 6₃), die der Trägerfläche (3; 3') gegenüberliegt, freizulegen.

3. Verfahren nach Anspruch 2, wobei die Schritte des Bildens der Vielzahl von Fotolumineszenz-Pads (6₁, 6₂) und des Bildens der reflektierenden Wände (10₁, 10₂) die folgenden Schritte beinhalten:
∘ Bilden einer Vielzahl von ersten Fotolumineszenz-Pads (6₁) durch Fotolithografie eines ersten Fotolacks (5₁), der erste Fotolumineszenzpartikel enthält und zuvor auf die Trägerfläche (3; 3') abgeschieden wurde;
∘ Bilden erster reflektierender Wände (10₁), die Seitenflanken (8₁) der ersten Fotolumineszenz-Pads (6₁) abdecken, durch ein ebenmäßiges Abscheiden einer reflektierenden Dünnschicht (9₁) auf die ersten Fotolumineszenz-Pads (6₁), gefolgt von einem lokalisierten Ätzen, um eine obere Fläche (7₁) der ersten Fotolumineszenz-Pads (6₁) freizulegen;
∘ Bilden einer Vielzahl von zweiten Fotolumineszenz-Pads (6₂) durch Fotolithografie eines zweiten Fotolacks (5₂), der zweite Fotolumineszenzpartikel enthält und zuvor auf die Trägerfläche (3; 3') abgeschieden wurde, wobei sich die zweiten Fotolumineszenzpartikel von den ersten Fotolumineszenzpartikeln unterscheiden.

4. Verfahren nach Anspruch 3, das im Anschluss an den Schritt des Bildens der Vielzahl von zweiten Fotolumineszenz-Pads (6₂) einen folgenden Schritt umfasst:
∘ Bilden zweiter reflektierender Wände (10₂), die Seitenflanken (8₂) der zweiten Fotolumineszenz-Pads (6₂) abdecken, durch ein ebenmäßiges Abscheiden einer reflektierenden Dünnschicht (9₂) auf die ersten und zweiten Fotolumineszenz-Pads (6₁, 6₂), gefolgt von einem lokalisierten Ätzen, um die obere Fläche (7₁, 7₂) der ersten und zweiten Fotolumineszenz-Pads (6₁, 6₂) freizulegen.

5. Verfahren nach Anspruch 3 oder 4, wobei jedes zweite Fotolumineszenz-Pad (6₂) mit mindestens einer ersten reflektierenden Wand (10₁) in Kontakt ist.

6. Verfahren nach einem der Ansprüche 2 bis 5, wobei jede erste reflektierende Wand (10₁) eine Dicke zwischen 10 nm und 500 nm aufweist.

7. Verfahren nach Anspruch 1, wobei der Schritt des Bildens der Vielzahl von Fotolumineszenz-Pads (6₁, 6₂, 6₃) mindestens ein Bilden mehrerer erster Fotolumineszenz-Pads (6₁), die erste Fotolumineszenzpartikel enthalten, gefolgt von einem Bilden mehrerer zweiter Fotolumineszenz-Pads (6₂), die zweite Fotolumineszenzpartikel enthalten, die sich von den ersten Fotolumineszenzpartikeln unterscheiden, umfasst, wobei der Schritt des Bildens der reflektierenden Wände (10₁, 10₂, 10₃) nach dem Bilden mindestens der ersten und zweiten Fotolumineszenz-Pads (6₁, 6₂) erfolgt.

8. Verfahren nach Anspruch 7, wobei die reflektierenden Wände (10₁, 10₂, 10₃) durch elektrochemisches Abscheiden gebildet werden.

9. Verfahren nach einem der Ansprüche 1 bis 8, wobei die Fotolumineszenzpartikel Quantenpunkte sind und eine mittlere Größe kleiner als oder gleich 50 nm aufweisen.

10. Verfahren nach einem der Ansprüche 1 bis 9, wobei die Elektrolumineszenzdioden (4) längliche dreidimensionale Elemente sind, die sich längs im Wesentlichen orthogonal zu einer Hauptebene einer Trägerschicht (25, 37) erstrecken.

11. Verfahren nach einem der Ansprüche 10, wobei sich die Elektrolumineszenzdioden (4) im Inneren der Pads (6₁, 6₂, 6₃) aus Fotolack befinden, wobei mindestens ein Teil der Pads (6₁, 6₂, 6₃) Fotolumineszenz-Pads sind, die Fotolumineszenzpartikel umfassen.

12. Verfahren nach einem der Ansprüche 1 bis 10, wobei die Fotolumineszenz-Pads (6₁, 6₂, 6₃) auf einer Trägerfläche (3), die als Übertragungsfläche bezeichnet wird, aufliegen, die durch eine Abstandsschicht (12), die die Elektrolumineszenzdioden (4) abdeckt, gebildet wird.

13. Optoelektronische Vorrichtung (1), die Folgendes umfasst:
∘ eine Matrix von Elektrolumineszenzdioden (4), die auf einer Trägerschicht aufliegen;
∘ eine Vielzahl von ersten Fotolumineszenz-Pads (6₁), die sich jeweils gegenüber mindestens einem Teil der Elektrolumineszenzdioden (4) befinden, die jeweils aus einem ersten Fotolack (5₁), der erste Fotolumineszenzpartikel umfasst, gebildet sind, die Seitenflanken (8₁) aufweisen, die durch einen abgeschiedenen Dünnschichtabschnitt, der eine erste reflektierende Wand (10₁) bildet, abgedeckt sind;
∘ eine Vielzahl von zweiten Fotolumineszenz-Pads (6₂), die sich jeweils gegenüber mindestens einem Teil der Elektrolumineszenzdioden (4) befinden, die jeweils aus einem zweiten Fotolack (5₂), der zweite Fotolumineszenzpartikel, die sich von den ersten Fotolumineszenzpartikeln unterscheiden, umfasst, gebildet sind, die Seitenflanken (8₂) aufweisen, die durch einen abgeschiedenen Dünnschichtabschnitt, der eine zweite reflektierende Wand (10₂) bildet, abgedeckt sind, wobei jedes zweite Fotolumineszenz-Pad (6₂) mit einer ersten reflektierenden Wand (10₁) in Kontakt ist.

14. Optoelektronische Vorrichtung (1) nach Anspruch 13, wobei die Elektrolumineszenzdioden (4) eine längliche dreidimensionale Struktur gemäß einer Längsachse, die im Wesentlichen orthogonal zu der Trägerschicht (25, 37) ist, aufweisen.

15. Optoelektronische Vorrichtung (1) nach Anspruch 13 oder 14, wobei sich die Elektrolumineszenzdioden (4) im Inneren der Fotolumineszenz-Pads (6₁, 6₂) befinden.

16. Optoelektronische Vorrichtung (1) nach Anspruch 13, wobei die Elektrolumineszenzdioden (4) eine Mesastruktur aufweisen.

## Claims

1. **Method** for producing an optoelectronic device (1) comprising a matrix array of light-emitting diodes (4) and a plurality of photoluminescent pads (6₁, 6₂, 6₃...) each located facing at least a portion of said light-emitting diodes (4), comprising the following steps:
∘ forming said plurality of photoluminescent pads (6₁, 6₂, 6₃...) via photolithography of at least one photoresist (5₁, 5₂, 5₃...) containing photoluminescent particles previously deposited on a carrier surface (3; 3');
∘ forming reflective walls (10₁, 10₂, 10₃...) covering lateral flanks (8₁, 8₂, 8₃...) of said photoluminescent pads (6₁, 6₂, 6₃...) by depositing at least a portion of thin layer (9₁, 9₂, 9₃...) on the lateral flanks (8₁, 8₂, 8₃...).

2. Method according to Claim 1, wherein the step of forming the reflective walls (10₁, 10₂, 10₃) comprises conformal deposition of at least one thin layer (9₁, 9₂, 9₃) of a reflective material so as to cover the photoluminescent pads (6₁, 6₂, 6₃), then localized etching of the deposited thin layer (9₁, 9₂, 9₃) so as to free an "upper" surface (7₁, 7₂, 7₃) of the photoluminescent pads (6₁, 6₂, 6₃) opposite said carrier surface (3; 3').

3. Method according to Claim 2, wherein the steps of forming the plurality of photoluminescent pads (6₁, 6₂), and of forming the reflective walls (10₁, 10₂) comprise the following steps:
∘ forming a plurality of first photoluminescent pads (6₁), via photolithography of a first photoresist (5₁) containing first photoluminescent particles previously deposited on said carrier surface (3; 3');
∘ forming first reflective walls (10₁) covering lateral flanks (8₁) of said first photoluminescent pads (6₁) by conformally depositing a reflective thin layer (9₁) on the first photoluminescent pads (6₁), then localized etching so as to free an upper surface (7₁) of the first photoluminescent pads (6₁);
∘ forming a plurality of second photoluminescent pads (6₂), via photolithography of a second photoresist (5₂) containing second photoluminescent particles previously deposited on said carrier surface (3; 3'), the second photoluminescent particles being different from the first photoluminescent particles.

4. Method according to Claim 3, comprising, following the step of forming the plurality of second photoluminescent pads (6₂), a step of:
∘ forming second reflective walls (10₂) covering lateral flanks (8₂) of said second photoluminescent pads (6₂) by conformally depositing a reflective thin layer (9₂) on the first and second photoluminescent pads (6₁, 6₂), then localized etching so as to free the upper surface (7₁, 7₂) of the first and second photoluminescent pads (6₁, 6₂).

5. Method according to Claim 3 or 4, wherein each second photoluminescent pad (6₂) is in contact with at least one first reflective wall (10₁).

6. Method according to any one of Claims 2 to 5, wherein each first reflective wall (10₁) has a thickness of between 10 nm and 500 nm.

7. Method according to Claim 1, wherein the step of forming the plurality of photoluminescent pads (6₁, 6₂, 6₃) comprises at least one formation of a plurality of first photoluminescent pads (6₁) containing first photoluminescent particles followed by a formation of a plurality of second photoluminescent pads (6₂) containing second photoluminescent particles different from the first photoluminescent particles, the step of forming the reflective walls (10₁, 10₂, 10₃) being performed after the formations of at least the first and second photoluminescent pads (6₁, 6₂).

8. Method according to Claim 7, wherein the reflective walls (10₁, 10₂, 10₃) are formed by electrochemical deposition.

9. Method according to any one of Claims 1 to 8, wherein the photoluminescent particles are quantum dots, and have an average size smaller than or equal to 50 nm.

10. Method according to any one of Claims 1 to 9, wherein the light-emitting diodes (4) are elongate three-dimensional elements extending longitudinally substantially orthogonally to a main plane of a carrier layer (25, 37).

11. Method according to any one of Claims 10, wherein the light-emitting diodes (4) are located inside the pads (6₁, 6₂, 6₃) of photoresist, at least a portion of which pads (6₁, 6₂, 6₃) are photoluminescent pads comprising photoluminescent particles.

12. Method according to any one of Claims 1 to 10, wherein the photoluminescent pads (6₁, 6₂, 6₃) rest on a carrier surface (3), called the transmission surface, formed by a spacer layer (12) covering the light-emitting diodes (4).

13. Optoelectronic device (1), comprising:
∘ a matrix array of light-emitting diodes (4) resting on a carrier layer;
∘ a plurality of first photoluminescent pads (6₁), each located facing at least a portion of said light-emitting diodes (4), each formed of a first photoresist (5₁) comprising first photoluminescent particles, having lateral flanks (8₁) covered with a portion of deposited thin layer forming a first reflective wall (10₁);
∘ a plurality of second photoluminescent pads (6₂), each located facing at least a portion of said light-emitting diodes (4), each formed of a second photoresist (5₂) comprising second photoluminescent particles different from the first photoluminescent particles, having lateral flanks (8₂) covered with a portion of deposited thin layer forming a second reflective wall (10₂), each second photoluminescent pad (6₂) being in contact with a first reflective wall (10₁).

14. Optoelectronic device (1) according to Claim 13, wherein the light-emitting diodes (4) have a three-dimensional structure that is elongate along a longitudinal axis substantially orthogonal to the carrier layer (25, 37).

15. Optoelectronic device (1) according to Claim 13 or 14, wherein the light-emitting diodes (4) are located inside the photoluminescent pads (6₁, 6₂).

16. Optoelectronic device (1) according to Claim 13, wherein the light-emitting diodes (4) have a mesa structure.
